# EUROPEAN PATENT APPLICATION

(11) **EP 4 750 254 A1**
(43) Date of publication of application: **27.05.2026**
(21) Application number: 25216520.4
(22) Date of filing: 18.11.2025
(51) Int. Cl.: H10D 30/62, H10D 62/10, H10D 64/01, H10D 84/01, H10D 84/83

(54) **SEMICONDUCTOR DEVICE AND METHOD OF MANUFACTURING THE SAME**

(30) Priority: 21.11.2024 KR 20240167758; 24.03.2025 KR 20250037508; 14.04.2025 KR 20250048363
(71) Applicant: Samsung Electronics Co., Ltd., Suwon-si, Gyeonggi-do 16677 (KR)
(72) Inventor: KIM, Deokhwan, 16677 Suwon-si (KR); KIM, Sungmin, 16677 Suwon-si (KR); KIM, Jaemyeong, 16677 Suwon-si (KR); KIM, Jeonggeol, 16677 Suwon-si (KR); LEE, Yongkyung, 16677 Suwon-si (KR)
(74) Representative: Elkington and Fife LLP

(57) **Abstract**

A semiconductor device may include a support structure layer, channel structures protruding from a first surface of the support structure layer and including a semiconductor material, source/drain structures on the first surface at both ends of of the channel structures, gate structures spaced apart from each other on the first surface in a second direction parallel to the first surface and different from a first direction and surrounding three surfaces of each of the channel structures at different positions in the second direction, back contact electrodes connected to some of the source/drain structures and exposed on the second surface, and sacrificial structures provided inside the support structure layer and supporting other ones of the source/drain structures. The support structure layer includes first and second dielectric layers. The second dielectric layer is provided between the first dielectric layer and the channel structures and has the same thickness as the sacrificial structures.

## Description

### FIELD OF THE INVENTION

Some embodiments of the present disclosure relate to a semiconductor device and a method of manufacturing the semiconductor device.

### BACKGROUND OF THE INVENTION

Transistors, which are semiconductor devices functioning as electrical switches, are employed in various integrated circuit devices including memory, driving integrated circuits (ICs), logic devices, and the like. Transistors having a three-dimensional structure in which a gate electrode surrounds three surfaces of a channel have been proposed to increase the integration density of integrated circuit devices and to enhance gate controllability

In the manufacture of semiconductor devices integrating such three-dimensional transistors, the process of connecting source/drain structures to backside wiring may cause attack on gate electrodes or channels. Therefore, methods of forming back contact electrodes while minimizing process-induced defects are being explored.

### SUMMARY OF THE INVENTION

According to an embodiment of the present disclosure, a semiconductor device including back contact electrodes and a method of manufacturing the semiconductor device may be provided.

According to an embodiment of the present disclosure, a semiconductor device may include: a support structure layer including a first dielectric layer and a second dielectric layer; a plurality of channel structures spaced apart from each other, in a first direction parallel to a first surface of the support structure layer, on the first surface of the support structure layer, the plurality of channel structures protruding in a fin shape in a direction away from the support structure layer, and including a semiconductor material; a plurality of source/drain structures on the first surface of the support structure layer at opposite ends of each of the plurality of channel structures; a plurality of gate structures spaced apart from each other, in a second direction parallel to the first surface and different from the first direction, on the first surface of the support structure layer, the plurality of gate structures surrounding three surfaces of each of the plurality of channel structures at different positions in the second direction; back contact electrodes connected to first source/drain structures among the plurality of source/drain structures, the back contact electrodes penetrating the support structure layer, and exposed at a second surface of the support structure layer, opposite to the first surface; and sacrificial structures inside the support structure layer and supporting second source/drain structures among the plurality of source/drain structures, wherein the first dielectric layer is under and apart from the plurality of channel structures, and wherein the second dielectric layer is between the first dielectric layer and the plurality of channel structures, and a thickness of a portion of the second dielectric layer directly below the plurality of channel structures is equal to a thickness of the sacrificial structures.

There is proposed a semiconductor structure comprising a multilayer support stack formed of dielectric layers with distinct etch selectivities (e.g. a first silicon oxide layer and a second silicon nitride or oxynitride layer) arranged beneath channel fins. Sacrificial SiGe structures may be positioned within the support stack to temporarily support certain source/drain regions during processing. Selective removal of the sacrificial structures may then allow back contact electrodes to be formed through the support stack, providing electrical connection to selected source/drain regions while maintaining the integrity of the remaining device layers.

Proposed embodiments may achieve improved manufacturability and device reliability by controlling the relative thicknesses of the dielectric and sacrificial layers such that the thickness of the second dielectric layer directly below the channels equals that of the sacrificial structures. This dimensional matching may enable precise etching and back contact definition with reduced risk of over-etching or channel attack.

A corresponding fabrication method may define the following sequential steps: constructing stacked three-dimensional silicon/sacrificial/silicon layers, introducing dummy gates, patterning isolation and dielectric layers with differing etch rates, and subsequently removing sacrificial regions to form back contacts. This may produce continuous lateral alignment between dielectric profiles and gate structures, ensuring structural and electrical uniformity.

The proposed architecture may be integrated into logic, memory, and display driver circuits, allowing compact, high-performance devices suitable for next-generation CMOS, SRAM, and display driver IC applications.

According to an embodiment of the present disclosure, the first dielectric layer and the second dielectric layer have different etching rates from each other.

According to an embodiment of the present disclosure, the first dielectric layer includes silicon oxide, and wherein the second dielectric layer includes silicon nitride, silicon oxynitride, silicon carbonitride, or silicon carbon oxynitride.

According to an embodiment of the present disclosure, the sacrificial structures include a material that is different from a material of the first dielectric layer or a material of the second dielectric layer.

According to an embodiment of the present disclosure, the sacrificial structures include SiGe.

According to an embodiment of the present disclosure, the first dielectric layer includes a plurality of regions respectively facing the plurality of channel structures and spaced apart from each other.

According to an embodiment of the present disclosure, the plurality of regions of the first dielectric layer each include a shape extending from the second surface of the support structure layer into the support structure layer.

According to an embodiment of the present disclosure, the support structure layer further includes residual sacrificial patterns respectively between the first dielectric layer and the plurality of channel structures, the residual sacrificial patterns including a material that is identical to a material of the sacrificial structures.

According to an embodiment of the present disclosure, the residual sacrificial patterns have a thickness that is equal to the thickness of the sacrificial structures.

According to an embodiment of the present disclosure, the residual sacrificial patterns face regions between the plurality of gate structures.

According to an embodiment of the present disclosure, regions of the second dielectric layer and the residual sacrificial patterns are alternately arranged in the second direction, and the regions of the second dielectric layer and the residual sacrificial patterns are between the plurality of regions of the first dielectric layer and the plurality of channel structures.

According to an embodiment of the present disclosure, the second dielectric layer does not overlap with the plurality of channel structures in a third direction perpendicular to the first surface of the support structure layer, and wherein the second dielectric layer includes a first region and a plurality of second regions, the first region extending to a predetermined thickness from the second surface of the support structure layer toward the first surface of the support structure layer, and the plurality of second regions protruding from the first region to the first surface of the support structure layer.

According to an embodiment of the present disclosure, the plurality of second regions face the plurality of gate structures, respectively.

According to an embodiment of the present disclosure, a lateral surface profile of the plurality of second regions and a lateral surface profile of the plurality of gate structures are continuous with respect to each other.

According to an embodiment of the present disclosure, the support structure layer further includes a third dielectric layer between the plurality of second regions, the third dielectric layer including a material that is identical to a material of the first dielectric layer.

According to an embodiment of the present disclosure, the support structure layer further includes a fourth dielectric layer that is conformally along a shape of the second dielectric layer and between the second dielectric layer and the third dielectric layer.

According to an embodiment of the present disclosure, the fourth dielectric layer extends along lateral surfaces of the plurality of gate structures from lateral surfaces of the plurality of second regions.

According to an embodiment of the present disclosure, the fourth dielectric layer includes a material that is identical to a material of the second dielectric layer.

According to an embodiment of the present disclosure, an electronic apparatus may include: a semiconductor device; and a controller configured to control the semiconductor device, wherein the semiconductor device includes: a support structure layer including a first dielectric layer and a second dielectric layer; a plurality of channel structures spaced apart from each other, in a first direction parallel to a first surface of the support structure layer, on the first surface of the support structure layer, the plurality of channel structures protruding in a fin shape in a direction away from the support structure layer, and including a semiconductor material; a plurality of source/drain structures on the first surface of the support structure layer at opposite ends of each of the plurality of channel structures; a plurality of gate structures spaced apart from each other, in a second direction parallel to the first surface and different from the first direction, on the first surface of the support structure layer, the plurality of gate structures surrounding three surfaces of each of the plurality of channel structures at different positions in the second direction; back contact electrodes connected to first source/drain structures among the plurality of source/drain structures, the back contact electrodes penetrating the support structure layer, and exposed at a second surface of the support structure layer, opposite to the first surface; and sacrificial structures inside the support structure layer and supporting second source/drain structures among the plurality of source/drain structures, wherein the first dielectric layer is under and apart from the plurality of channel structures, and wherein the second dielectric layer is between the first dielectric layer and the plurality of channel structures, and a thickness of the second dielectric layer directly below the plurality of channel structures is equal to a thickness of the sacrificial structures.

According to an embodiment of the present disclosure, a method of manufacturing a semiconductor device may include: forming a plurality of three-dimensional structures on a bulk silicon layer, the plurality of three-dimensional structures being arranged with respect to each other in a first direction, and each of the plurality of three-dimensional structures including a first silicon layer, a sacrificial material layer, and a second silicon layer; forming an isolation layer, between the plurality of three-dimensional structures, on the bulk silicon layer; forming a plurality of dummy gates on the plurality of three-dimensional structures, the plurality of dummy gates crossing the plurality of three-dimensional structures and arranged with respect to each other in a second direction different from the first direction; patterning the isolation layer using a hard mask used to form the plurality of dummy gates; forming, on the isolation layer that is patterned, a support structure layer including a plurality of types of dielectric layers having different etching rates from each other; forming, after the forming the support structure layer, a plurality of source/drain structures in contact with opposite ends of the second silicon layer and in contact with an upper surface of the sacrificial material layer of each of the plurality of three-dimensional structures; exposing portions of the sacrificial material layer by removing the bulk silicon layer and the isolation layer; forming sacrificial structures in contact with the plurality of source/drain structures by removing exposed portions of the sacrificial material layer; and forming a back contact electrode connected to one of the plurality of source/drain structures, the back contact electrode exposed at a back surface of the support structure layer.

Additional aspects of the present disclosure will be set forth in part in the description which follows and, in part, will be apparent from the description, or may be learned by practice of the presented example embodiments of the present disclosure.

### BRIEF DESCRIPTION OF DRAWINGS

The above and other aspects, features, and advantages of certain embodiments of the present disclosure will be more apparent from the following description taken in conjunction with the accompanying drawings, in which:
FIG. 1 is a perspective view schematically illustrating a structure of a semiconductor device according to an embodiment;
FIG. 2A is a plan view illustrating the semiconductor device shown in FIG. 1;
FIGS. 2B, 2C, and 2D are cross-sectional views respectively taken along lines BB, CC, and DD of FIG. 2A;
FIG. 2E is a cross-sectional view taken along the line EE of FIG. 2A not passing through the channel structures CH;
FIG. 3 is a perspective view schematically illustrating a structure of a semiconductor device according to another embodiment;
FIGS. 4A and 4B are cross-sectional views respectively taken along lines AA and BB of FIG. 3;
FIG. 5 is a flowchart schematically illustrating a method of manufacturing a semiconductor device, according to an embodiment;
FIGS. 6 to 29E are views illustrating an example of a method of manufacturing a semiconductor device, according to an embodiment;
FIG. 30 is a block diagram schematically illustrating a display driver integrated circuit (display driver IC or DDI) and a display apparatus including the DDI, according to an embodiment;
FIG. 31 is a circuit diagram illustrating a complementary metal-oxide-semiconductor (CMOS) inverter according to an embodiment;
FIG. 32 is a circuit diagram illustrating a CMOS static random-access memory (SRAM) device according to an embodiment;
FIG. 33 is a circuit diagram including a CMOS NAND circuit according to an embodiment;
FIG. 34 is a block diagram illustrating an electronic apparatus according to an embodiment; and
FIG. 35 is a block diagram illustrating an electronic apparatus according to an embodiment.

### DETAILED DESCRIPTION

Reference will now be made in detail to non-limiting example embodiments of the present disclosure, examples of which are illustrated in the accompanying drawings. In this regard, embodiments of the present disclosure may have different forms and should not be construed as being limited to the descriptions set forth herein. Accordingly, the example embodiments are merely described below, by referring to the figures, to explain example aspects of the present disclosure. As used herein, the term "and/or" includes any and all combinations of one or more of the associated listed items. Expressions such as "at least one of," when preceding a list of elements, modify the entire list of elements and do not modify the individual elements of the list.

Hereinafter, non-limiting example embodiments will be described with reference to the accompanying drawings. The example embodiments described herein are for illustrative purposes only, and various modifications may be made therein. In the drawings, like reference numerals refer to like elements, and the sizes of elements may be exaggerated for clarity of illustration.

In the following description, when an element is referred to as being "above" or "on" another element, it may be directly on the other element while making contact with the other element or may be above the other element without making contact with the other element.

Although the terms "first" and "second" are used to describe various elements, these terms are only used to distinguish one element from another element. These terms do not limit elements to having different materials or structures.

The terms of a singular form may include plural forms unless otherwise mentioned. It will be further understood that the terms "comprises" (or "includes") and/or "comprising" (or "including") used herein specify the presence of stated features or elements, but do not preclude the presence or addition of one or more other features or elements.

In the present disclosure, terms such as "unit" or "module" may be used to denote a unit that has at least one function or operation and is implemented with hardware, software, or a combination of hardware and software.

An element referred to with the definite article or a demonstrative determiner may be construed as the element or the elements even though it has a singular form.

Operations of a method may be performed in any appropriate order unless described to the contrary. In addition, examples or terms (e.g., "such as" and "etc.") are used for the purpose of description and are not intended to limit the scope of the present disclosure.

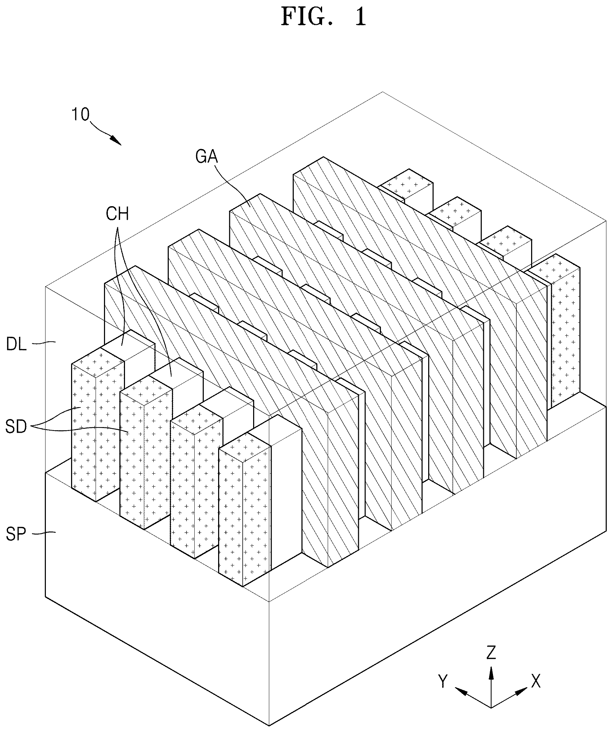

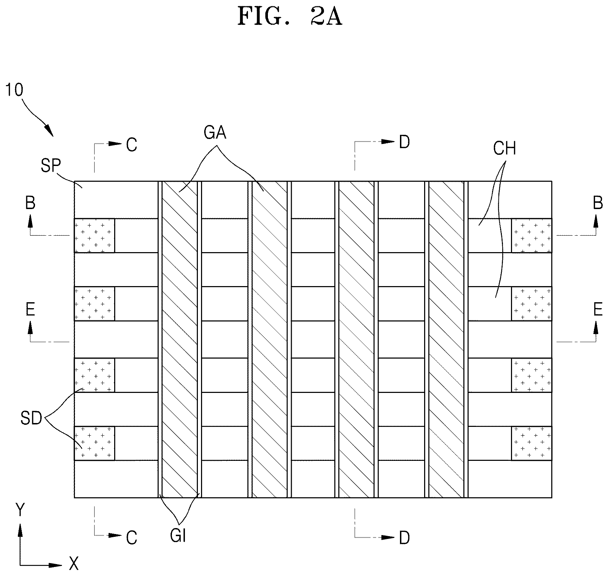

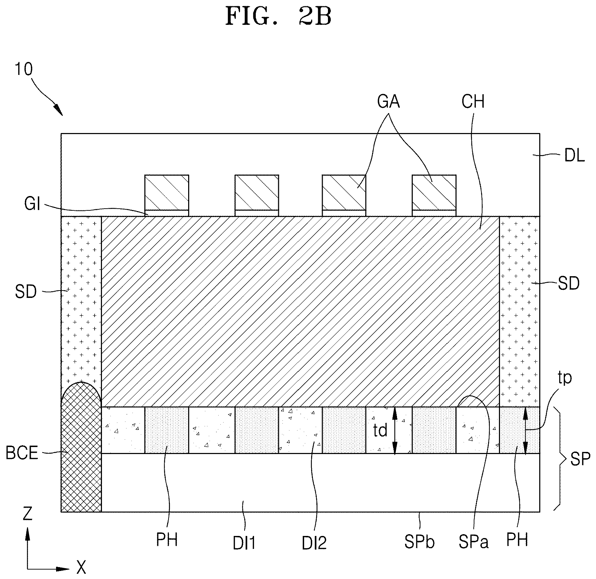

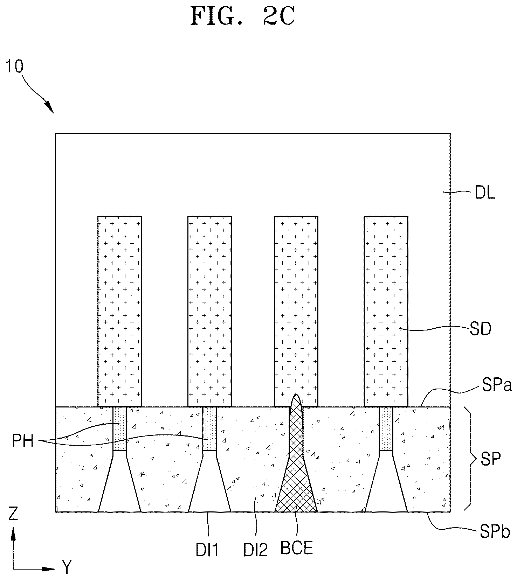

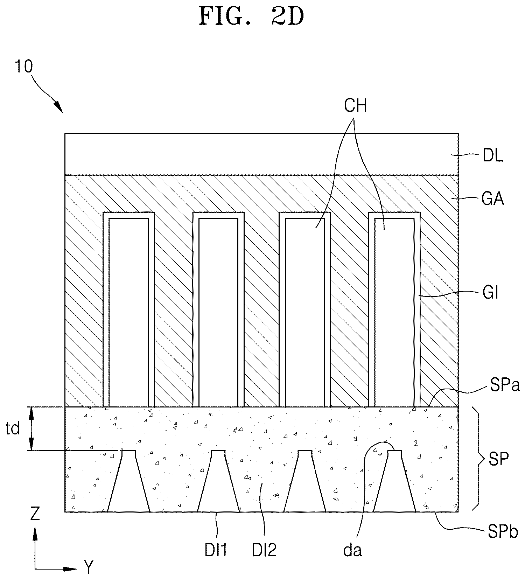

FIG. 1 is a perspective view schematically illustrating a structure of a semiconductor device 10 according to an embodiment. FIG. 2A is a plan view illustrating the semiconductor device 10 shown in FIG. 1, and FIGS. 2B, 2C, and 2D are cross-sectional views respectively taken along lines BB, CC, and DD of FIG. 2A.

The semiconductor device 10 may include a support structure layer SP, and a plurality of channel structures CH and a plurality of gate electrodes GA that are arranged on the support structure layer SP. Source/drain structures SD may be respectively arranged on both ends of each of the channel structures CH. A gate insulating layer GI may be provided between the channel structures CH and the gate electrodes GA. A dielectric layer DL that entirely covers the channel structures CH and the gate electrodes GA may be formed on the support structure layer SP. The dielectric layer DL may include one or more types of dielectric materials.

The semiconductor device 10 may be a fin field effect transistor (fin-FET) device. The channel structures CH may be arranged apart from each other in a first direction (e.g., Y-direction) on a first surface SPa of the support structure layer SP, and the gate electrodes GA may be arranged apart from each other in a second direction (e.g., X-direction) on the first surface SPa of the support structure layer SP. The gate electrodes GA may surround three surfaces of each of the channel structures CH at a plurality of positions in the second direction. The number of channel structures CH and the number of gate electrodes GA shown in FIGS. 1 to 2E are only examples. For example, as many transistor channels as the number of intersections between the channel structures CH and the gate electrodes GA may be defined. In FIG. 1, details of the support structure layer SP or the gate insulating layer GI are omitted for ease of illustration.

As shown in FIGS. 2B and 2C, some of the source/drain structures SD may be connected to back contact electrodes BCE exposed on a second surface SPb (e.g., lower surface) of the support structure layer SP, and sacrificial structures PH may be disposed under the other source/drain structures SD that are not connected to the back contact electrodes BCE. The sacrificial structures PH may include, for example, SiGe. Although FIGS. 2B and 2C illustrate that one source/drain structure SD is connected to a back contact electrode BCE, this is only an example, and embodiments are not limited thereto. The number and positions of source/drain structures SD connected to the back contact electrodes BCE may be variously selected.

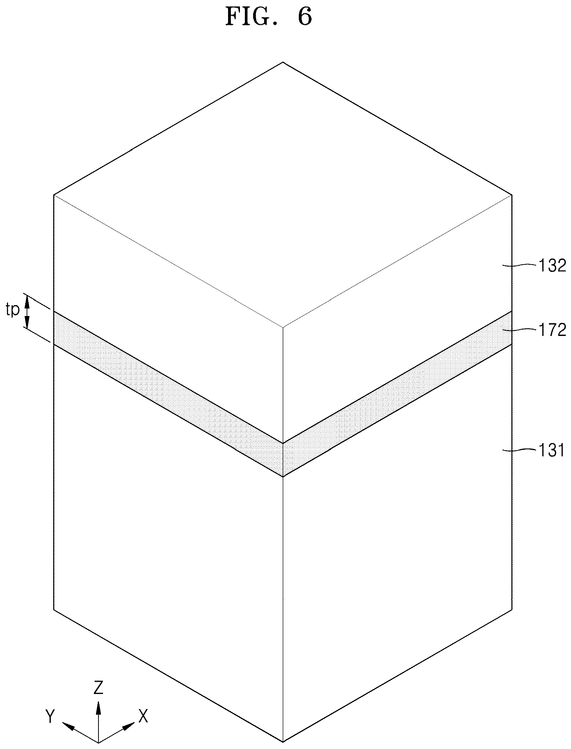

Referring to FIG. 2B, the sacrificial structures PH may be formed alternately and repeatedly with a second dielectric layer DI2 in the second direction (e.g., X direction). The sacrificial structures PH may be positioned to face the gate electrodes GA. The width of the sacrificial structures PH is not limited to the illustrated form and may be smaller than the width of the gate electrodes GA. The sacrificial structures PH may be patterns formed by a sacrificial material layer used in processes of forming the channel structures CH and the source/drain structures SD. The sacrificial material layer may be formed to entirely support lower portions of the channel structures CH and the source/drain structures SD. Thereafter, the sacrificial material layer may be patterned to remove portions of the sacrificial material layer, and the remaining portions of the sacrificial material layer may remain unetched under all of the source/drain structures SD, thereby forming the sacrificial structures PH. Next, among the sacrificial structures PH, sacrificial structures PH located under source/drain structures SD that are to be directly connected to the back contact electrodes BCE may be selectively removed, and the back contact electrodes BCE may be formed to be in direct contact with the source/drain structures SD. An example of such a manufacturing method is described below with reference to FIG. 6 and subsequent drawings.

The support structure layer SP may have the first surface SPa and the second surface SPb. The support structure layer SP may include a plurality of types of dielectric materials. For example, the support structure layer SP may include a first dielectric layer DI1 and a second dielectric layer DI2. The first dielectric layer DI1 may include silicon oxide, and the second dielectric layer DI2 may include silicon nitride, silicon oxynitride, silicon carbonitride, or silicon carbon oxynitride. The second dielectric layer DI2 may include, for example, SiN, SiON, SiCN, or SiOCN. The first dielectric layer DI1 and the second dielectric layer DI2 may include materials having different etch rates from each other. The second dielectric layer DI2 may include a material having a lower etch rate than an etch rate of the first dielectric layer DI1.

As shown in FIGS. 2C and 2D, the first dielectric layer DI1 may form patterns extending into the support structure layer SP from the second surface SPb (e.g., the lower surface) of the support structure layer SP. As the position moves deeper from the lower surface of the support structure layer SP into the support structure layer SP, the first-direction (e.g., Y-direction) width of the patterns formed by the first dielectric layer DI1 may decrease. However, this is only an example, and embodiments are not limited thereto. The patterns formed by the first dielectric layer DI1 may include a plurality of end portions da that respectively face the channel structures CH at the same depth within the support structure layer SP.

The second dielectric layer DI2 may be disposed between the end portions da and the channel structures CH. The second dielectric layer DI2 may extend to the first surface SPa from the end portions da of the patterns formed by the first dielectric layer DI1. In addition, the second dielectric layer DI2 may extend in the direction in which the gate electrodes GA are arranged apart from each other, that is, in the second direction (e.g., X-direction), and may also extend along the second surface SPb of the support structure layer SP. The second dielectric layer DI2 may occupy most of the region of the support structure layer SP except for a region occupied by the first dielectric layer DI1.

A distance between the channel structures CH and the end portions da of the patterns formed by the first dielectric layer DI1, that is, the thickness of the second dielectric layer DI2 measured directly below the channel structures CH, may be equal to the thickness of the sacrificial structures PH.

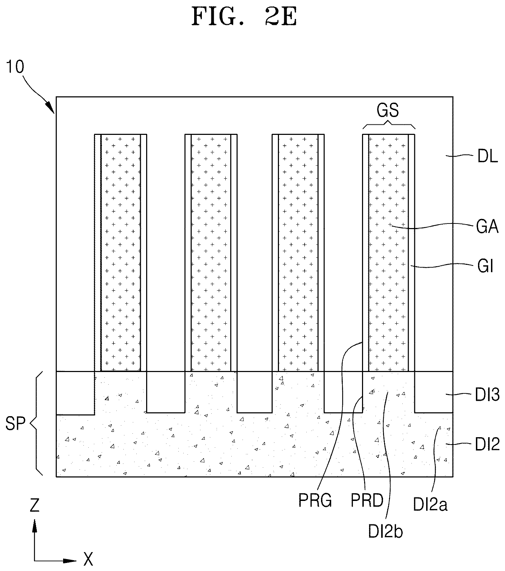

Referring to FIG. 2E, which is a cross-sectional view taken along the line EE not passing through the channel structures CH, the second dielectric layer DI2 may include: a first region DI2a that extends to a predetermined thickness position from the second surface SPb (e.g., the lower surface) of the support structure layer SP toward the first surface SPa (e.g., the upper surface) of the support structure layer SP; and a plurality of second regions DI2b that protrude from the predetermined thickness position to the second surface SPb. The second regions DI2b face the gate electrodes GA in a one-to-one manner. A lateral surface profile PRD of the second regions DI2b may be the same as a lateral surface profile PRG of gate structures GS. For example, lateral surfaces of the second regions DI2b and lateral surfaces of the gate structures GS may be coplanar with each other. Here, the gate structures GS may be structures including the gate electrodes GA and the gate insulating layer GI. However, embodiments are not limited to the case in which the width of the second regions DI2b is equal to the width of the gate structures GS. The lateral surface profile PRD of the second regions DI2b and the lateral surface profile PRG of the gate structures GS may result from a dummy gate process that precedes the formation of the gate structures GS. For example, as a result of patterning a material at the positions of the second regions DI2b by using a hard mask used in forming dummy gates, the lateral surface profile PRG of the gate structures GS and the lateral surface profile PRD of the second regions DI2b of the second dielectric layer DI2 may be continuous with each other in the semiconductor device 10 after the semiconductor device 10 is completely manufactured. An example of a manufacturing method related thereto is described below with reference to FIG. 6 and subsequent drawings.

A third dielectric layer DI3 may be disposed on both sides of each of the second regions DI2b. The third dielectric layer DI3 may include a material that is different from a material of the first dielectric layer DI1 or the second dielectric layer DI2. Alternatively, the third dielectric layer DI3 may include the same material as the first dielectric layer DI1.

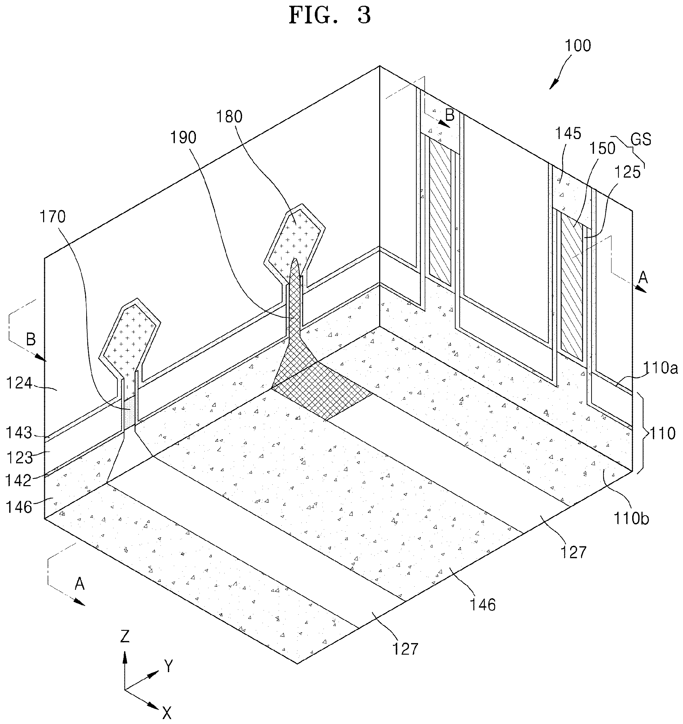

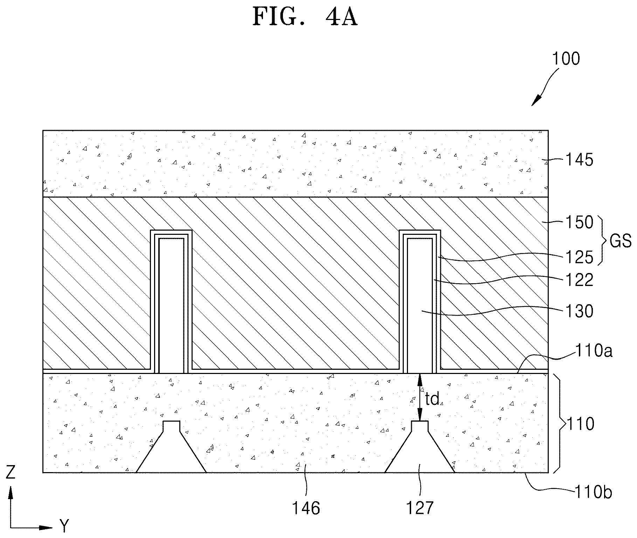

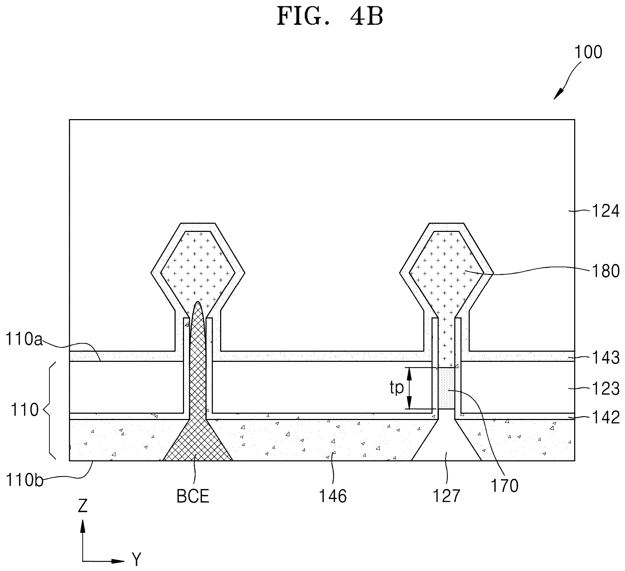

FIG. 3 is a perspective view schematically illustrating a structure of a semiconductor device 100 according to an embodiment, and FIGS. 4A and 4B are cross-sectional views respectively taken along lines AA and BB of FIG. 3.

The semiconductor device 100 may be a fin-FET device that is similar to the semiconductor device 10 described with reference to FIGS. 1 to 2E. The semiconductor device 100 may include a support structure layer 110, and a plurality of channel structures 130 and a plurality of gate electrodes 150 that are arranged on the support structure layer 110. Source/drain structures 180 may be disposed at both ends of each of the channel structures 130. A gate insulating layer 125 may be provided between the channel structures 130 and the gate electrodes 150.

The support structure layer 110 may include a plurality of types of dielectric materials. The support structure layer 110 may have a first surface 110a as an upper surface, and a second surface 110b as a back surface.

The channel structures 130, which protrude in a direction away from the support structure layer 110 and are arranged apart from each other in a first direction (e.g., Y-direction) parallel to the first surface 110a, may be formed on the first surface 110a.

The source/drain structures 180 may be formed on the first surface 110a of the support structure layer 110 at both ends of each of the channel structures 130. In FIGS. 3 to 4B, only the source/drain structures 180, each disposed on one end of each of the channel structures 130, are illustrated.

The gate electrodes 150 may be arranged on the first surface 110a of the support structure layer 110 apart from each other in a second direction (e.g., X-direction) that is different from the first direction and is parallel to the first surface 110a of the support structure layer 110. The gate electrodes 150 may surround three surfaces of each of the channel structures 130 at different positions in the second direction.

Some of the source/drain structures 180 may be connected to back contact electrodes 190, which may be formed to penetrate the support structure layer 110 and may be exposed on the second surface 110b (back surface) of the support structure layer 110. The other source/drain structures 180, which are not connected to the back contact electrodes 190, may be connected to sacrificial structures 170 provided inside the support structure layer 110.

The support structure layer 110 may include a plurality of types of dielectric materials having different etch rates from each other. The support structure layer 110 may include dielectric layers 127 and 146 having different etch rates from each other. The dielectric layer 127 may include silicon oxide, and the dielectric layer 146 may include silicon nitride, silicon oxynitride, silicon carbonitride, or silicon carbon oxynitride.

The dielectric layer 127 may include a plurality of regions respectively facing the channel structures 130 and arranged apart from each other. Like the arrangement direction of the channel structures 130, the arrangement direction of the regions of the dielectric layer 127 may also be the first direction (e.g., Y-direction). Each of the regions of the dielectric layer 127 (e.g., a first dielectric layer) may have a shape extending into the support structure layer 110 from the second surface 110b of the support structure layer 110. The shape of the dielectric layer 127 shown in FIGS. 3 to 4B is only an example, and embodiments are not limited thereto.

The dielectric layer 146 may be disposed between the dielectric layer 127 and the channel structures 130, and a thickness td of the dielectric layer 146 (e.g., a second dielectric layer), directly below the channel structures 130, may be equal to a thickness tp of the sacrificial structures 170. The thickness tp of the sacrificial structures 170 may not be constant because portions of the sacrificial structures 170 may be etched during a process of forming the source/drain structures 180. In other words, the thickness td of the dielectric layer 146 (e.g., the second dielectric layer), directly below the channel structures 130, may be different from the thickness tp of the sacrificial structures 170, or may be substantially equal to the thickness of a thickest portion of the sacrificial structures 170.

The support structure layer 110 may further include a dielectric layer 123 above the dielectric layer 146. The dielectric layer 123 may include the same material as the dielectric layer 127.

A dielectric layer 142 may be further formed between the dielectric layer 146 and the dielectric layer 123. The dielectric layer 142 may be conformally formed along the shape of the dielectric layer 146. At least a portion of the dielectric layer 146 may extend in a direction perpendicular to the first surface 110a of the support structure layer 110, and may also extend along lateral surfaces of gate structures GS. The gate structures GS may be structures including the gate electrodes 150 and the gate insulating layer 125. The dielectric layer 142 may include the same material as the dielectric layer 146.

A dielectric layer 143 may be further formed on the first surface 110a of the support structure layer 110. The dielectric layer 143 may have a shape surrounding the source/drain structures 180. The dielectric layer 143 may extend along the lateral surfaces of the gate structures GS. A dielectric layer 124 may be formed on the remaining region of the support structure layer 110. The dielectric layer 124 may include the same material as the dielectric layer 127 or the dielectric layer 123. However, embodiments are not limited thereto.

The structure of the semiconductor device 100 described above is presented as a result of a process of forming the back contact electrodes 190 in direct contact with the source/drain structures 180. The structure of the semiconductor device 100 is further described below in conjunction with a description of a manufacturing method.

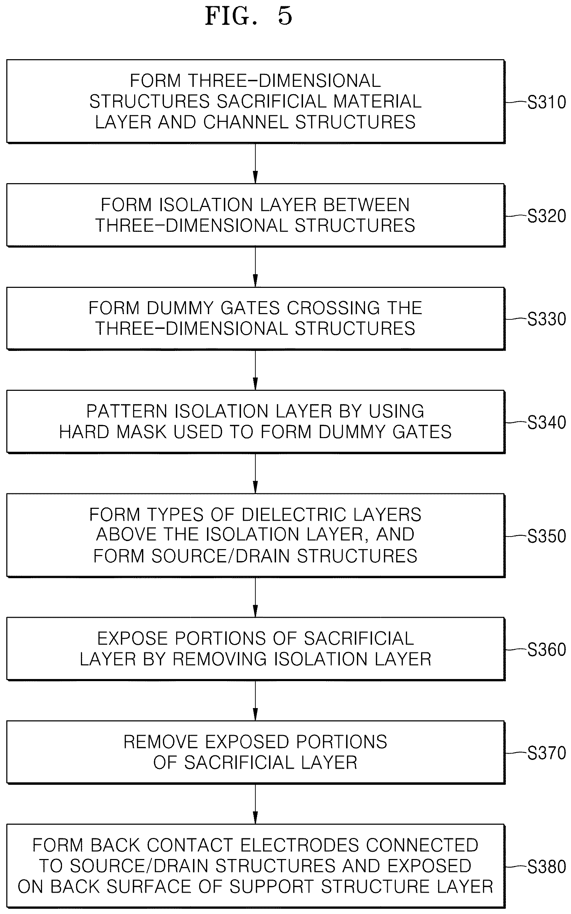

FIG. 5 is a flowchart schematically illustrating a method of manufacturing a semiconductor device, according to an embodiment.

First, a plurality of three-dimensional structures including a sacrificial material layer and channel structures may be formed (operation S310).

The three-dimensional structures may each include a first semiconductor layer, the sacrificial material layer, and a second semiconductor layer. The first and second semiconductor layers may include silicon. The three-dimensional structures may be formed on bulk silicon.

Next, an isolation layer may be formed between the three-dimensional structures (operation S320).

Next, a plurality of dummy gates may be formed across the three-dimensional structures (operation S330).

The isolation layer may be patterned using a hard mask used to form the dummy gates (operation S340).

Next, a plurality of types of dielectric layers may be formed above the isolation layer, and source/drain structures may be formed (operation S350).

The plurality of types of dielectric layers may include two or more dielectrics having different etch rates from each other. The plurality of types of dielectric layers formed as described above function as a support structure layer for removing the isolation layer in a subsequent operation. The source/drain structures may be in contact with both ends of the second semiconductor layer of each of the three-dimensional structures and may also be in contact with the sacrificial material layer.

Next, the isolation layer may be removed to expose portions of the sacrificial material layer (operation S360).

Next, the exposed portions of the sacrificial material layer may be removed (operation S370). The remaining portions of the sacrificial material layer may function as sacrificial structures that support the source/drain structures.

Next, back contact electrodes, which are connected to some of the source/drain structures and exposed on a back surface of the support structure layer, may be formed (operation S380). To form the back contact electrodes, a mask that exposes some of the source/drain structures to be connected to the back contact electrodes may be used to remove the sacrificial material layer making contact with the source/drain structures, and portions of the plurality of types of dielectric layers provided on the sacrificial material layer.

FIGS. 6 to 29E are views illustrating an example of the method of manufacturing a semiconductor device, according to an embodiment.

Referring to FIG. 6, a structure including a first semiconductor layer 131, a sacrificial material layer 172, and a second semiconductor layer 132 may be provided. The sacrificial material layer 172 and the second semiconductor layer 132 may be sequentially stacked on the first semiconductor layer 131. After forming the sacrificial material layer 172 on the first semiconductor layer 131, the second semiconductor layer 132 may be formed on the sacrificial material layer 172. The first semiconductor layer 131, the sacrificial material layer 172, and the second semiconductor layer 132 may be formed by a general semiconductor growth method.

The first semiconductor layer 131 and the second semiconductor layer 132 may include silicon, germanium (Ge), or a compound semiconductor. The first semiconductor layer 131 and the second semiconductor layer 132 may further include a P-type or N-type dopant. The first semiconductor layer 131 and the second semiconductor layer 132 may include the same semiconductor material as each other. However, embodiments are not limited thereto. The sacrificial material layer 172 may include SiGe. The thickness td of the sacrificial material layer 172 may be approximately 5 nm or more and 50 nm or less, but is not limited thereto.

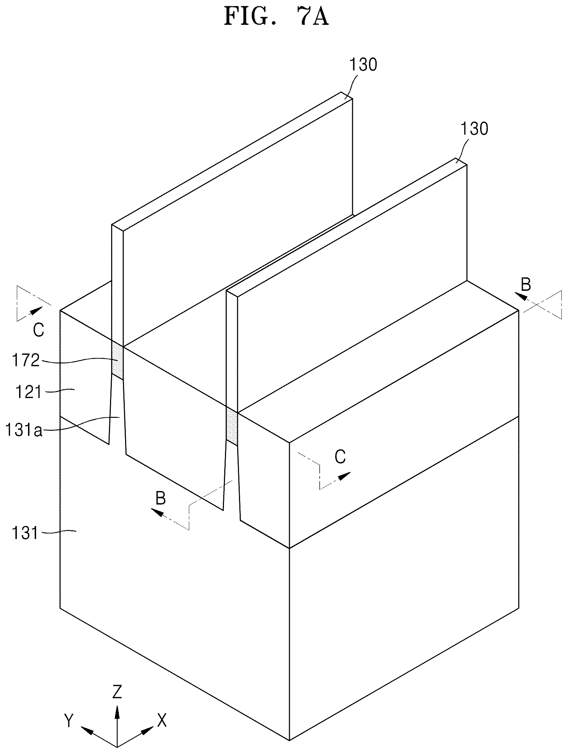

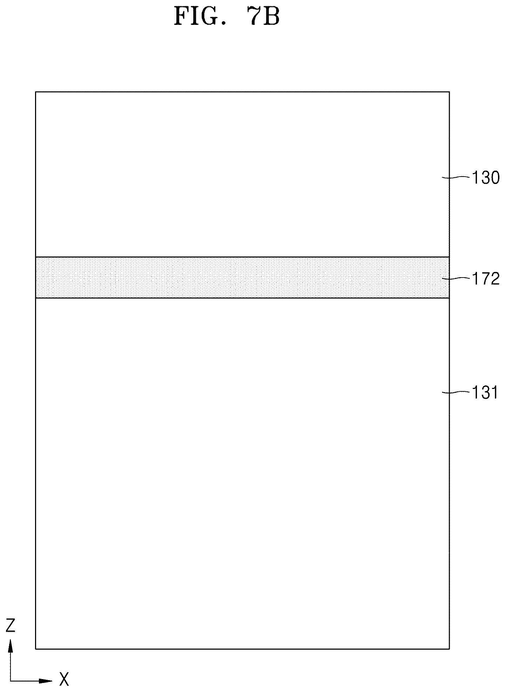

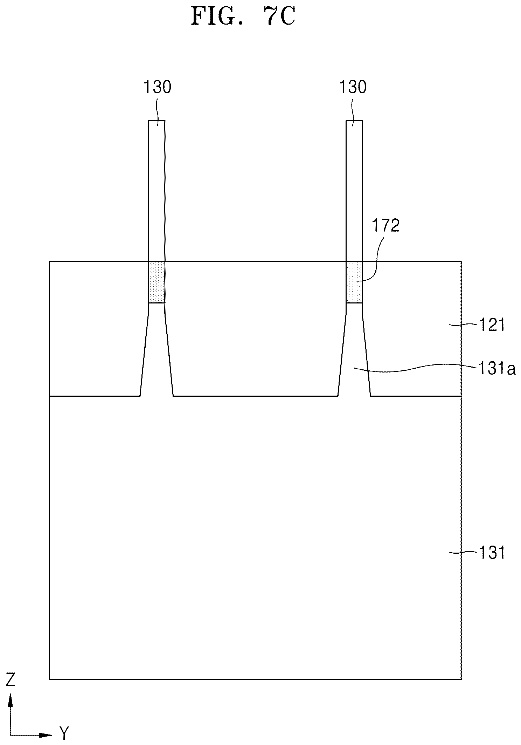

Referring to FIG. 7A, a structure may be provided in which a plurality of channel structures 130 are provided by patterning the second semiconductor layer 132. FIGS. 7B and 7C are cross-sectional views respectively taken along lines BB and CC of FIG. 7A.

In the structure shown in FIG. 6, the second semiconductor layer 132 may be first patterned to form the channel structures 130. Although two channel structures 130 are illustrated as examples, any number of channel structures 130 arranged in a first direction (e.g., Y-direction) may be formed. When forming the channel structures 130, the sacrificial material layer 172 and the first semiconductor layer 131 may also be patterned corresponding to the channel structures 130. The sacrificial material layer 172 may be etched to a depth corresponding to the thickness of the sacrificial material layer 172, and the first semiconductor layer 131 may be etched to a depth less than the thickness of the first semiconductor layer 131. Portions of the first semiconductor layer 131 that correspond in shape to the channel structures 130 may be referred to as first semiconductor layers 131a. Next, an isolation layer 121 may be formed in etched regions of the first semiconductor layer 131. That is, the isolation layer 121 may be formed in regions between the first semiconductor layers 131a that are patterned corresponding to the channel structures 130. The thickness of the isolation layer 121 may be determined such that the sacrificial material layer 172 is not exposed. The height position of an upper surface of the isolation layer 121, that is, the position of the upper surface of the isolation layer 121 in a third direction (e.g., Z-direction), that is, a stacking direction, may be higher than or equal to the height position of the sacrificial material layer 172. The height position of the upper surface of the isolation layer 121 shown in the drawings is only an example, and embodiments are not limited thereto. The isolation layer 121 may include a dielectric material such as, for example, silicon oxide.

The thickness td of the sacrificial material layer 172 is not limited to the illustrated thickness. For example, the sacrificial material layer 172 may be thinner than the channel structures 130 as shown in the drawings. However, embodiments are not limited thereto, and the sacrificial material layer 172 may be thicker than the channel structures 130.

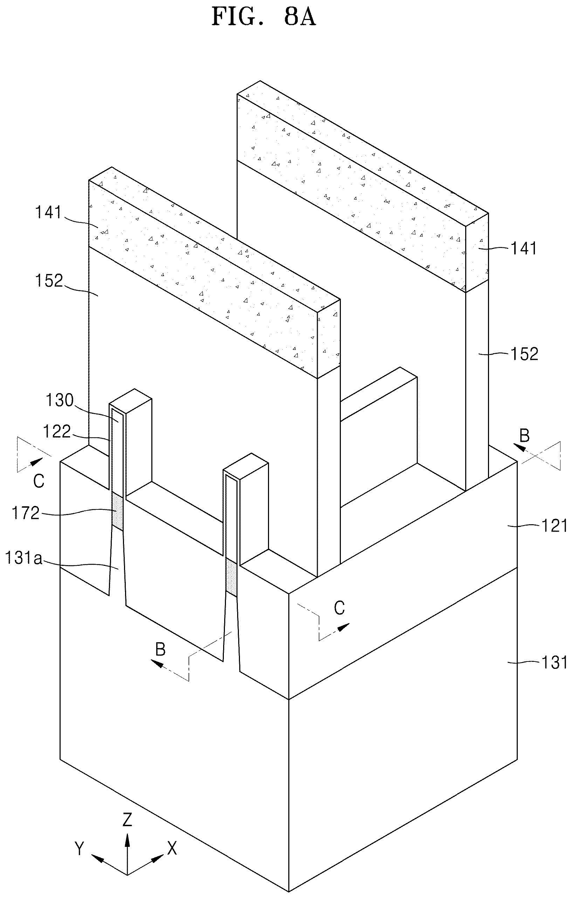

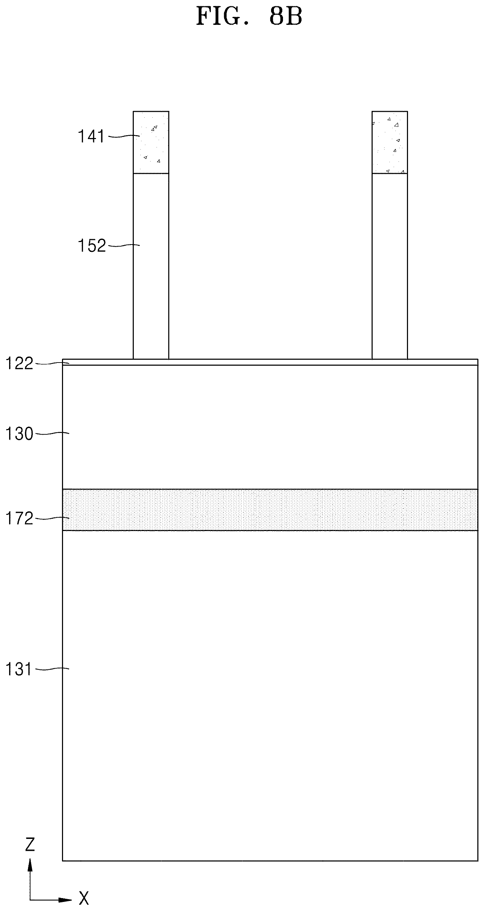

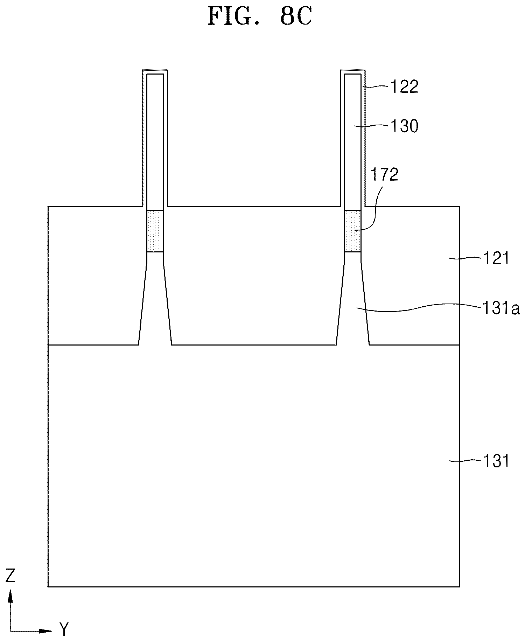

Referring to FIG. 8A, a structure in which dummy gates 152 are formed may be provided. FIGS. 8B and 8C are cross-sectional views respectively taken along lines BB and CC of FIG. 8A.

First, a dielectric layer 122 surrounding three surfaces of each of the channel structures 130 may be formed. The dielectric layer 122 may be conformally formed along the shape of the channel structures 130. The dielectric layer 122 may include a dielectric material. For example, the dielectric layer 122 may include the same dielectric material as the isolation layer 121. Next, a dummy material layer for forming the dummy gates 152 may be formed to entirely cover the channel structures 130 surrounded by the dielectric layer 122. Then, the dummy material layer may be patterned into a predetermined shape to form the dummy gates 152. The dummy material layer may include, for example, polysilicon (poly-Si). A dielectric layer 141 may be a hard mask used for patterning the dummy material layer. The dielectric layer 141 may include, for example, silicon nitride. The material of the dielectric layer 141 is not limited thereto. For example, the dielectric layer 141 may include SiN, SiOCN, SiON, or SiCN. The material of the dielectric layer 141 may have an etch rate that is different from the etch rate of the material of the isolation layer 121. For example, the material of the dielectric layer 141 may have a lower etch rate than the etch rate of the material of the isolation layer 121. Although two dummy gates 152 are illustrated, these are only examples. For example, any number of dummy gates 152 arranged in a second direction (e.g., X-direction) may be formed.

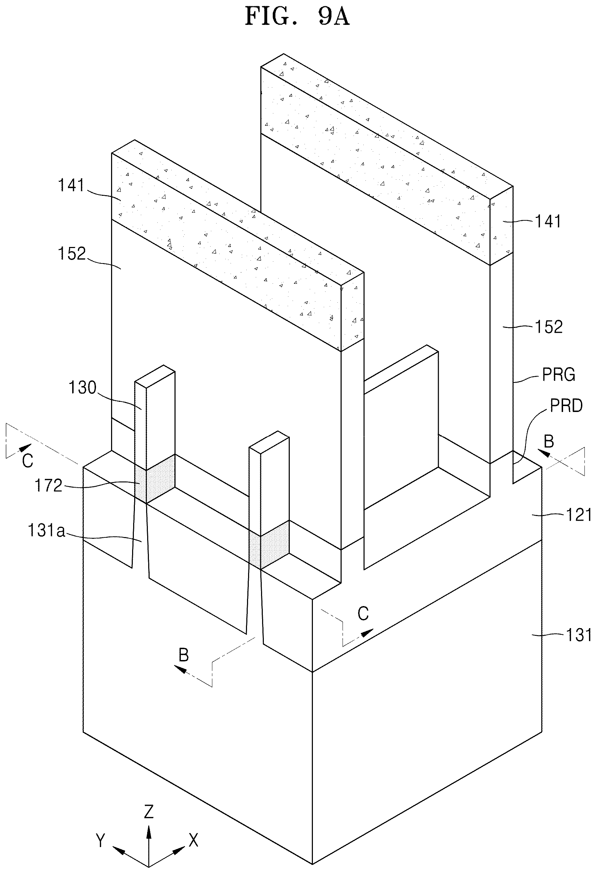

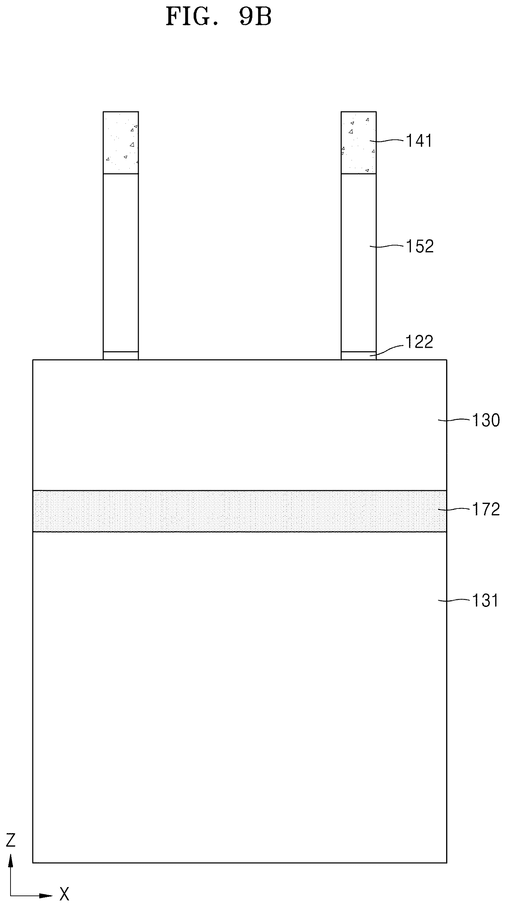

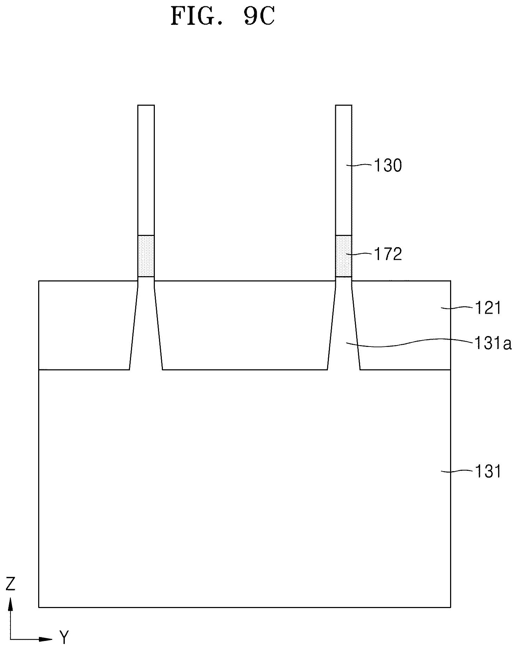

Referring to FIG. 9A, a structure is provided in which the isolation layer 121 is further etched. FIGS. 9B and 9C are cross-sectional views respectively taken along lines BB and CC of FIG. 9A.

The dielectric layer 141 used as a hard mask for patterning the dummy gates 152 may be used as an etch mask to etch the isolation layer 121. Therefore, protruding portions having a lateral surface profile PRD continuous with a lateral surface profile PRG of the dummy gates 152 may be formed on the isolation layer 121. The isolation layer 121 may be etched to a depth at which the sacrificial material layer 172 is entirely exposed. During the etching of the isolation layer 121, the dielectric layer 122 surrounding the channel structures 130 may be etched together. During the etching of the isolation layer 121, the dummy gates 152 may be protected by the dielectric layer 141 including a material having a lower etch rate than an etch rate of the isolation layer 121, and the dielectric layer 122 may remain between the dummy gates 152 and the channel structures 130.

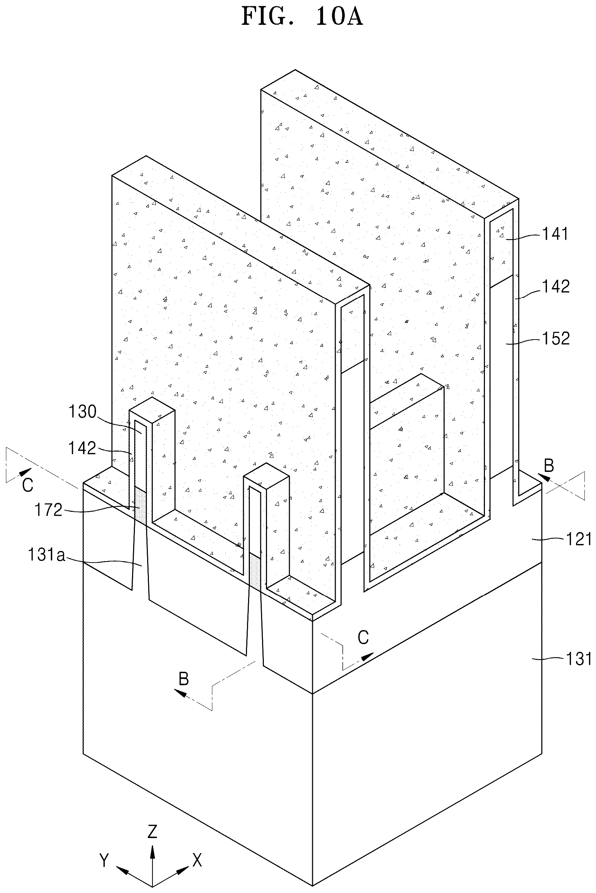

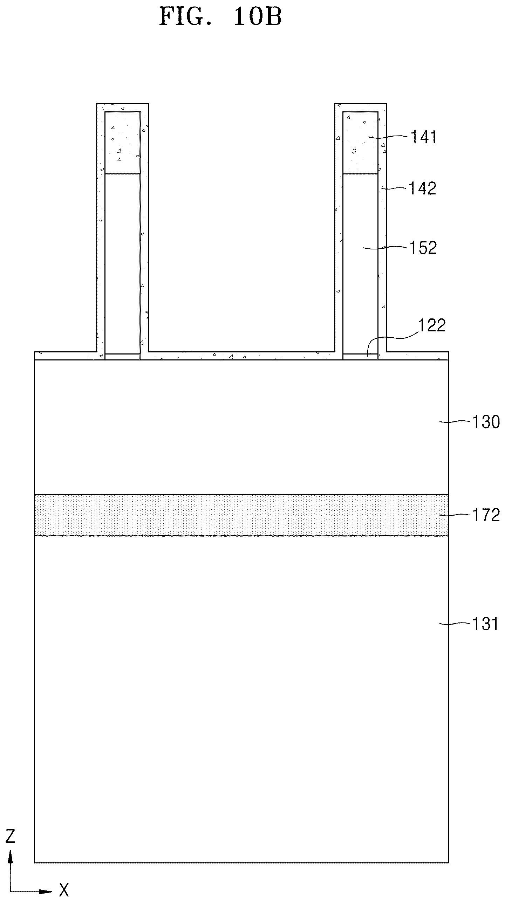

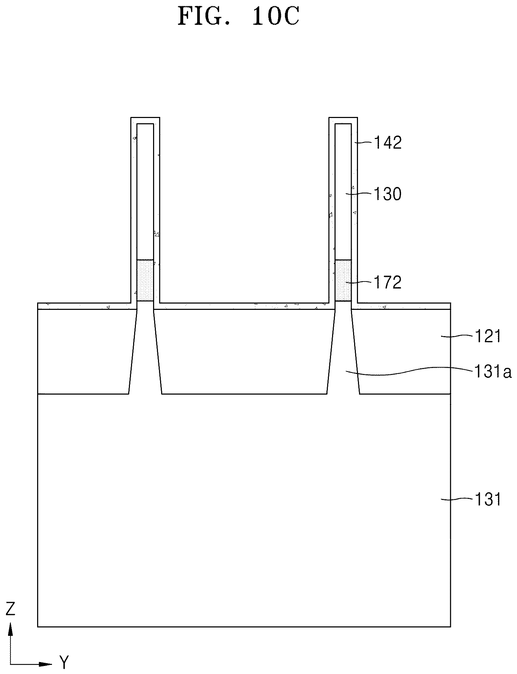

Referring to FIG. 10A, a structure may be provided in which a dielectric layer 142 is further formed on the isolation layer 121 and on a structure exposed above the isolation layer 121. FIGS. 10B and 10C are cross-sectional views respectively taken along lines BB and CC of FIG. 10A.

The dielectric layer 142 may be conformally formed entirely over the structure formed as shown in FIG. 9A. The dielectric layer 142 may include a material having a lower etch rate than an etch rate of the isolation layer 121. The dielectric layer 142 may include the same material as the dielectric layer 141. However, embodiments are not limited thereto. The dielectric layer 142 may serve as an etch stop layer in a subsequent process.

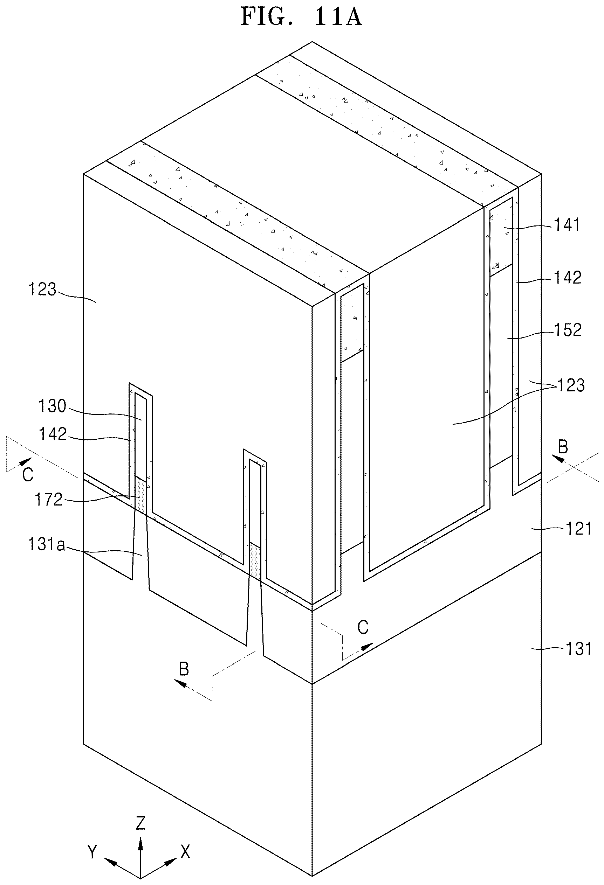

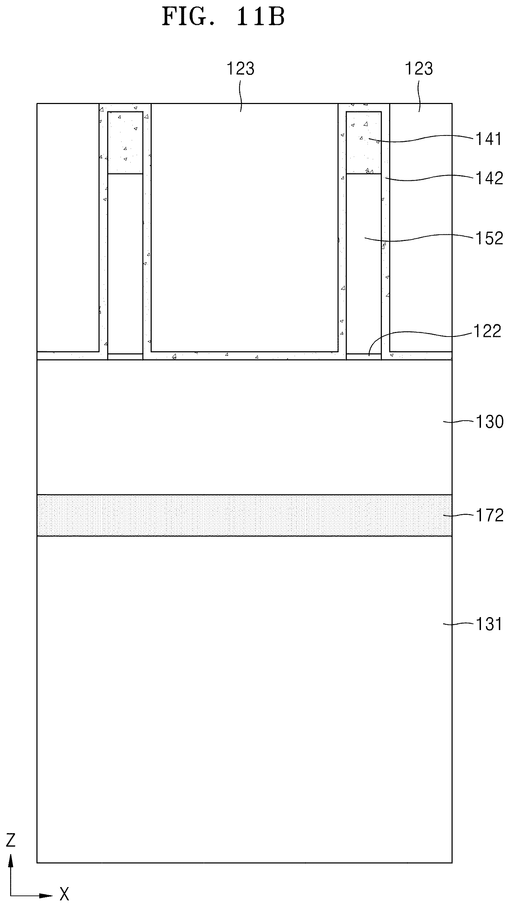

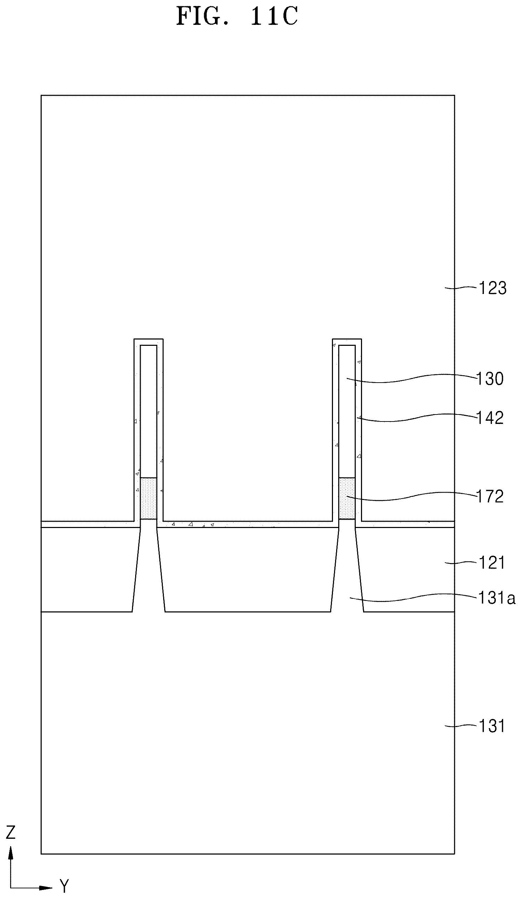

Referring to FIG. 11A, a structure may be provided in which a dielectric layer 123 is further formed on the structure formed as shown in FIG. 10A. FIGS. 11B and 11C are cross-sectional views respectively taken along lines BB and CC of FIG. 11A.

The dielectric layer 123 may uniformly and entirely cover the structure shown in FIG. 10A. The dielectric layer 123 may include the same dielectric material as the dielectric material included in the isolation layer 121, such as silicon oxide. However, embodiments are not limited thereto.

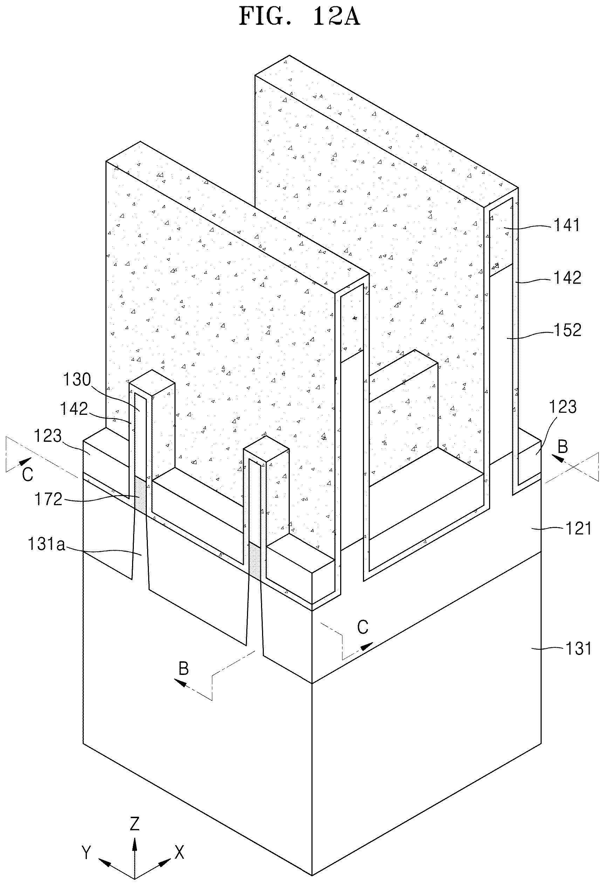

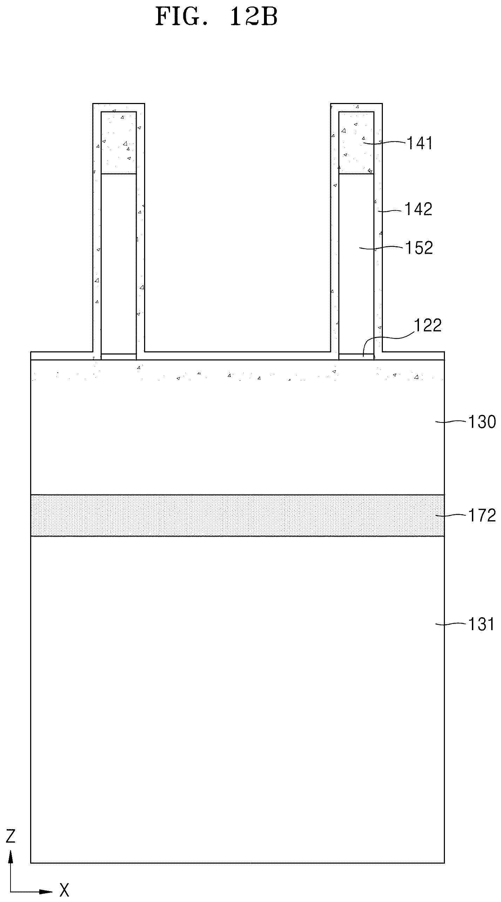

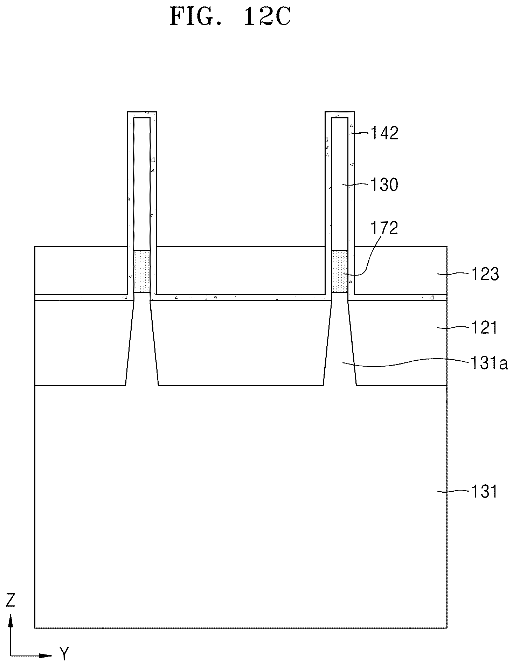

Referring to FIG. 12A, a structure may be provided in which the dielectric layer 123 is etched to a predetermined depth. FIGS. 12B and 12C are cross-sectional views respectively taken along lines BB and CC of FIG. 12A.

The height position of an upper surface of the dielectric layer 123 may be higher than or equal to the height position of an upper surface of the sacrificial material layer 172. That is, in the structure shown in FIG. 11A, the etching depth of the dielectric layer 123 may be determined such that the height position of the upper surface of the dielectric layer 123 is higher than or equal to the height position of the sacrificial material layer 172. The height position of the upper surface of the dielectric layer 123 may be, for example, equal to the height position of the isolation layer 121 shown in FIG. 7A. However, embodiments are not limited thereto.

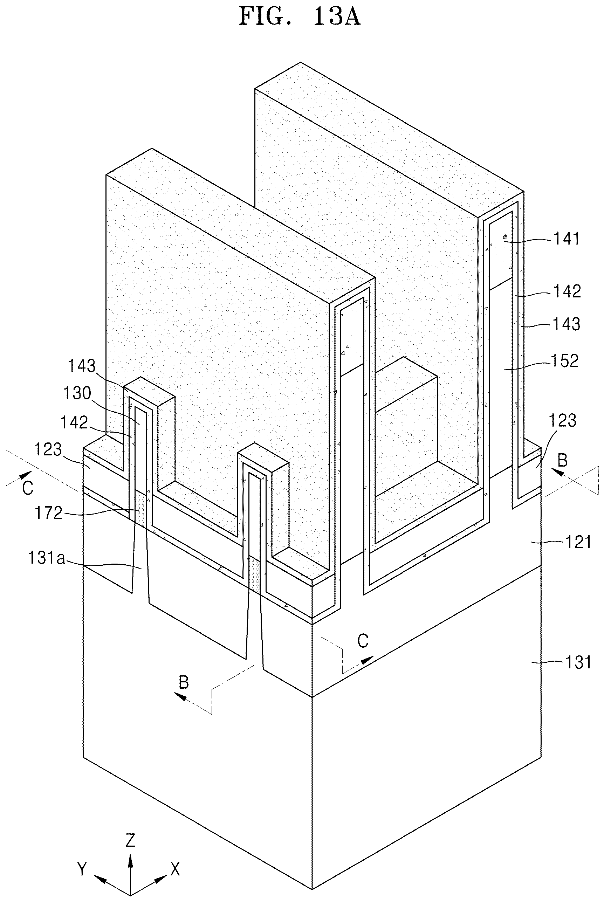

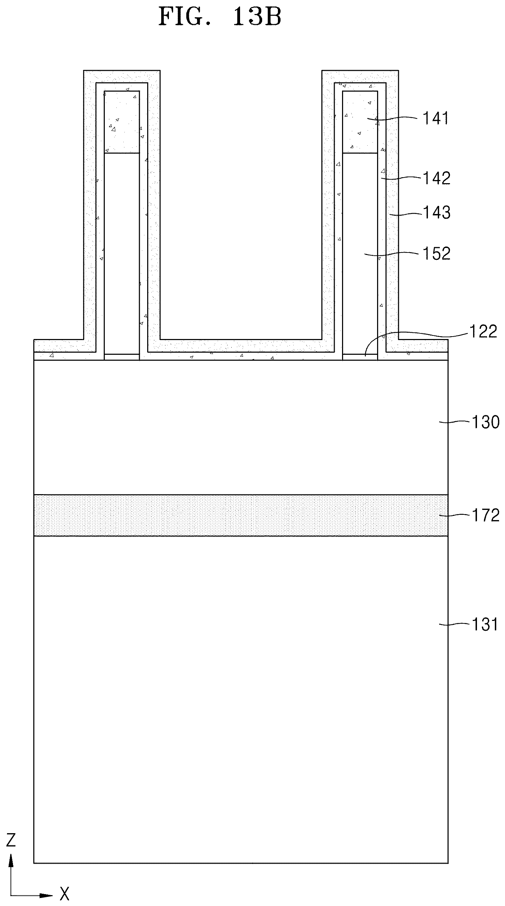

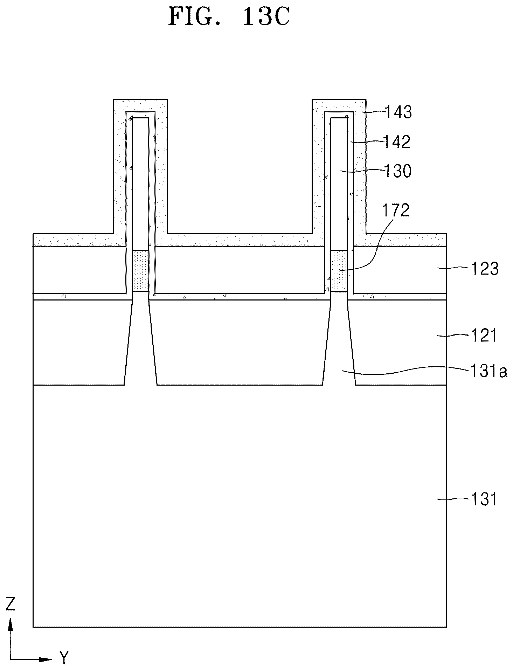

Referring to FIG. 13A, a structure may be provided in which a dielectric layer 143 is formed on the upper surface of the dielectric layer 123 and the surface of the dielectric layer 142. FIGS. 13B and 13C are cross-sectional views respectively taken along lines BB and CC of FIG. 13A.

The dielectric layer 143 may be conformally deposited on the upper surface of the dielectric layer 123 and the surface of the dielectric layer 142. The dielectric layer 143 may include SiOCN. However, the dielectric layer 143 is not limited thereto and may include SiN, SiON, or SiCN. The dielectric layer 143 may include the same material as the dielectric layer 142 or may include a material that is different from a material included in the dielectric layer 142.

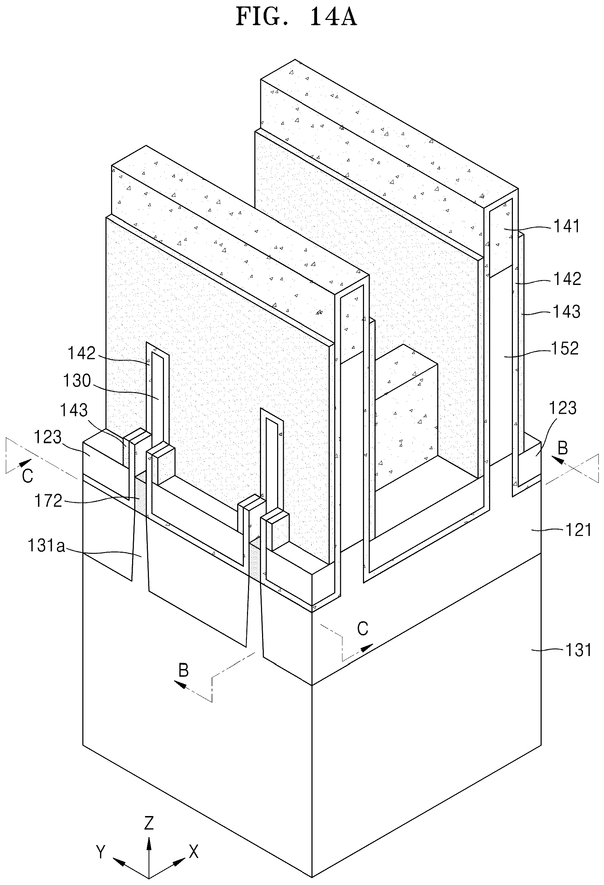

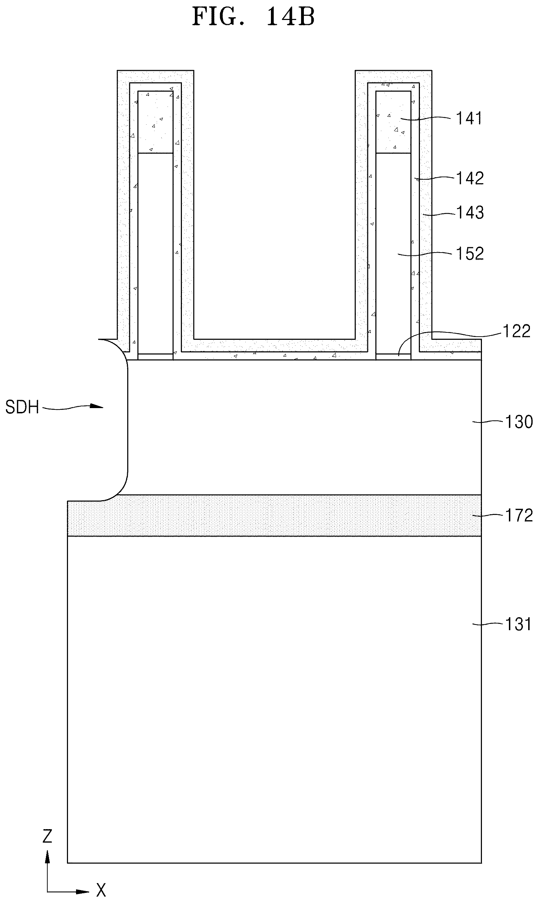

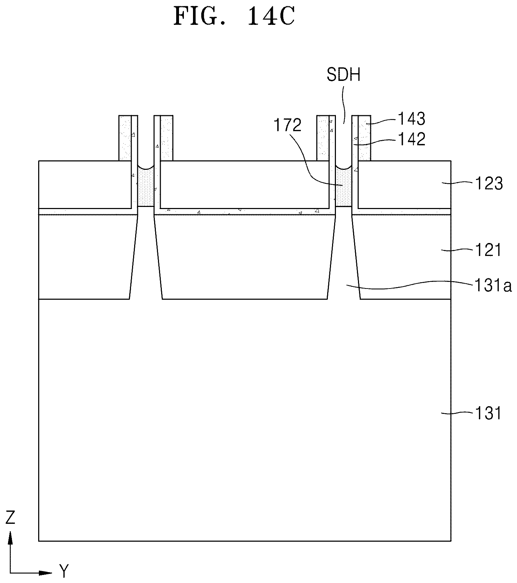

Referring to FIG. 14A, a structure may be provided in which ends of the channel structures 130 are etched. FIGS. 14B and 14C are cross-sectional views respectively taken along lines BB and CC of FIG. 14A.

Ends of the channel structures 130 provided on the sacrificial material layer 172 may be etched to form holes SDH for forming source/drain structures. In a process of etching the ends of the channel structures 130 provided on the sacrificial material layer 172, the sacrificial material layer 172 may also be partially etched. A partially etched shape of the sacrificial material layer 172 shown in FIG. 14C is only an example, and embodiments are not limited thereto. In the following drawings, this is not shown for ease of illustration.

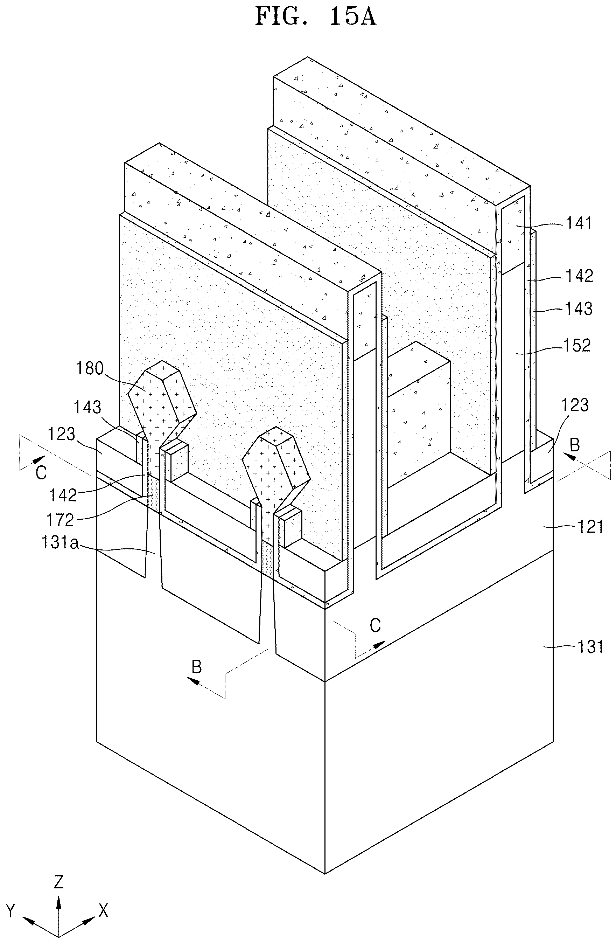

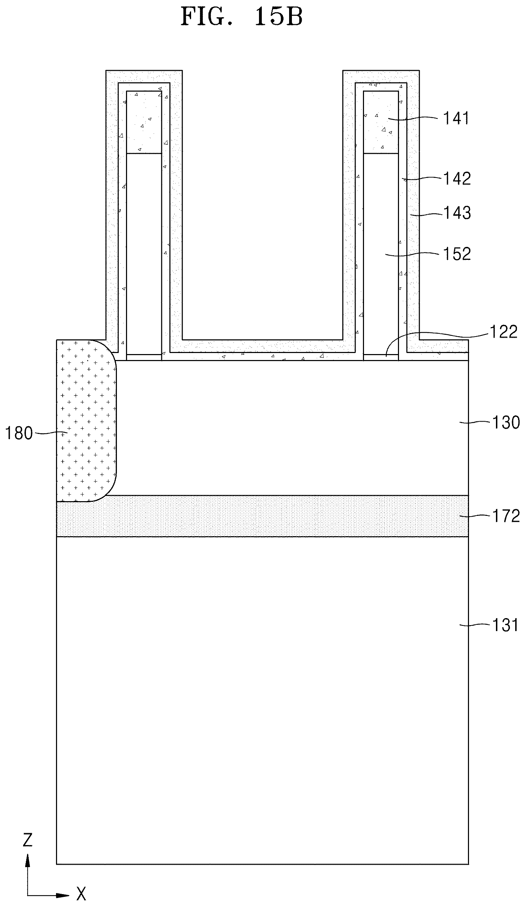

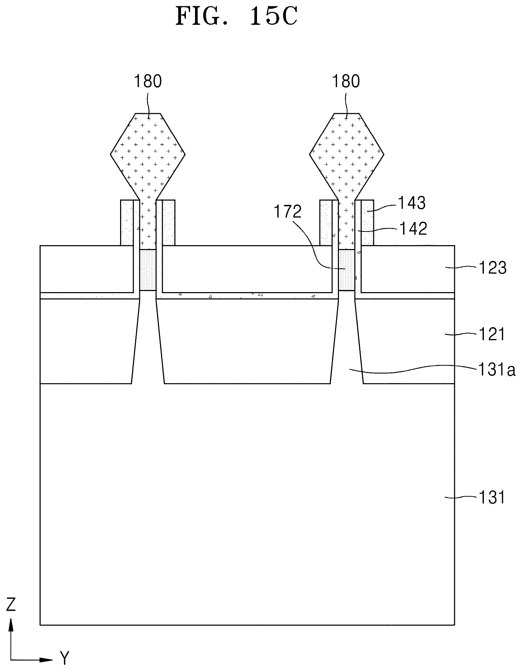

Referring to FIG. 15A, a structure may be provided in which source/drain structures 180 connected to ends of the channel structures 130 are formed. FIGS. 15B and 15C are cross-sectional views respectively taken along lines BB and CC of FIG. 15A.

The source/drain structures 180 may be grown from the channel structures 130, supported by the sacrificial material layer 172, and filled in the holes SDH shown in FIG. 14C. The source/drain structures 180 may include a semiconductor material and a P-type or N-type dopant. The source/drain structures 180 may be formed by, for example, a metal-organic chemical vapor deposition (MOCVD) method, but are not limited thereto.

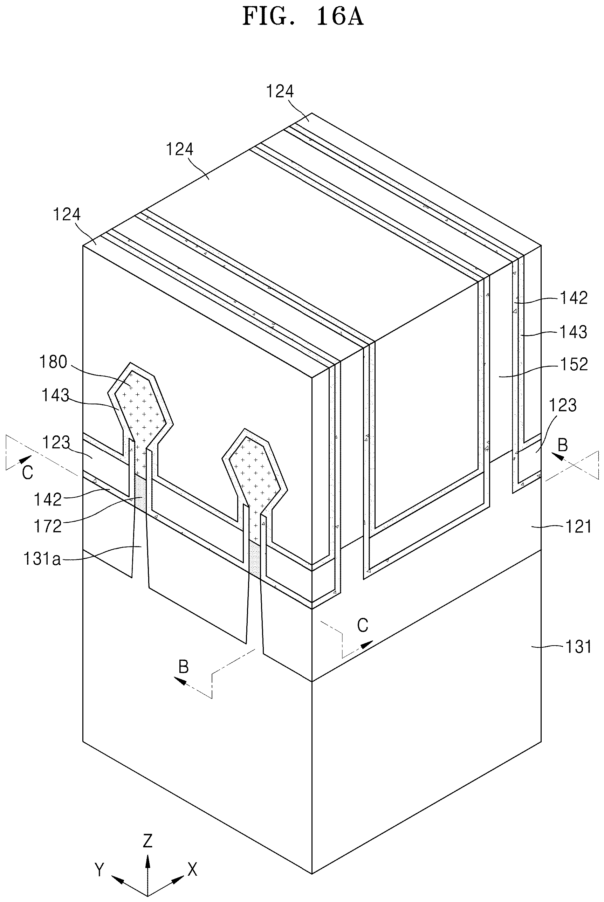

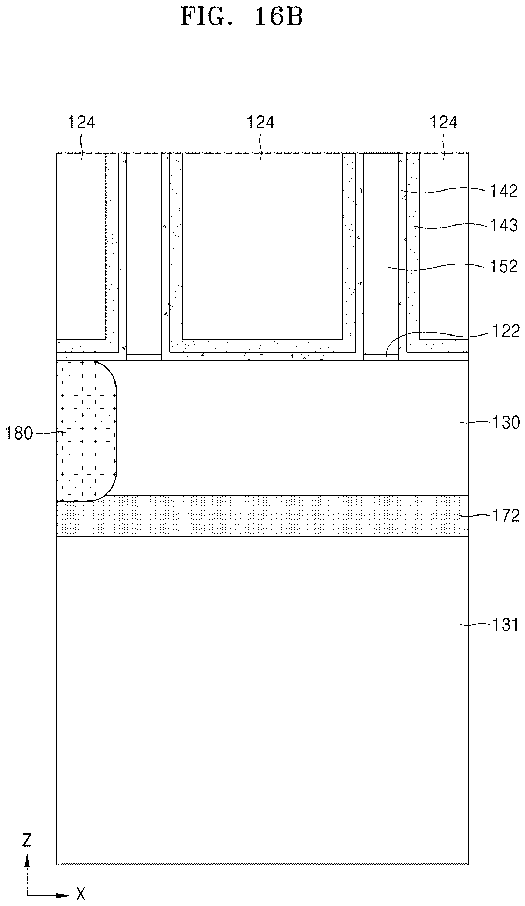

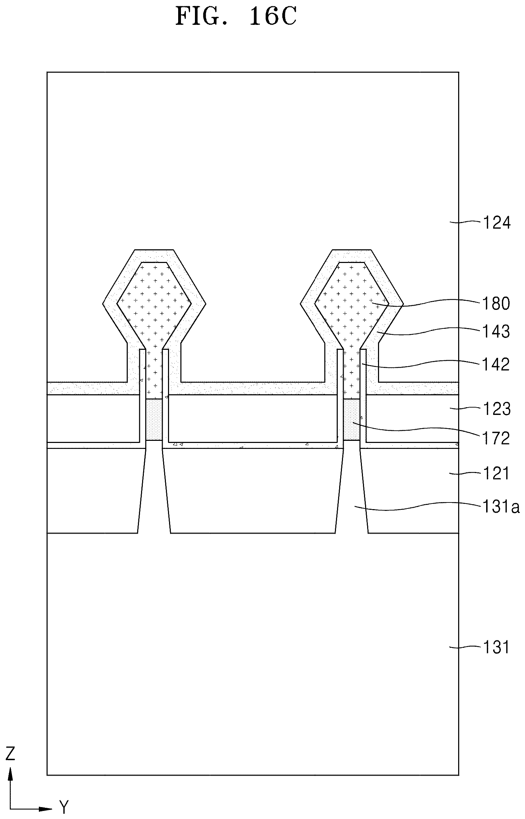

Referring to FIG. 16A, a structure may be provided in which the dielectric layer 143 is further deposited on the structure shown in FIG. 15A, and a dielectric layer 124 is formed for planarization. FIGS. 16B and 16C are cross-sectional views respectively taken along lines BB and CC of FIG. 16A.

The dielectric layer 143 may be conformally formed along the surface of the structure shown in FIG. 15A, and then, the dielectric layer 124 may fill the remaining space. The dielectric layer 124 may include the same material as the isolation layer 121, the dielectric layer 122, or the dielectric layer 123. The dielectric layer 124 may include, for example, silicon oxide. However, embodiments are not limited thereto. A planarization process may be performed until upper surfaces of the dummy gates 152 are exposed.

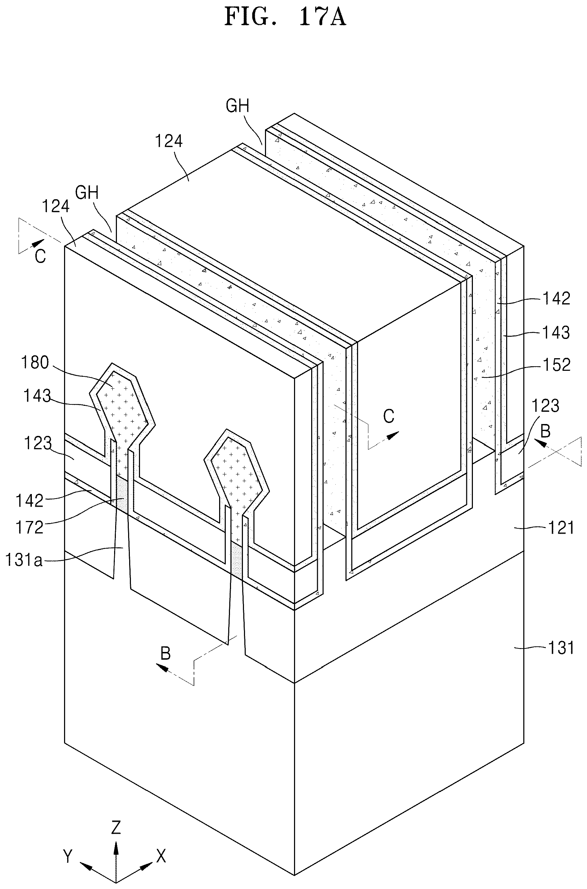

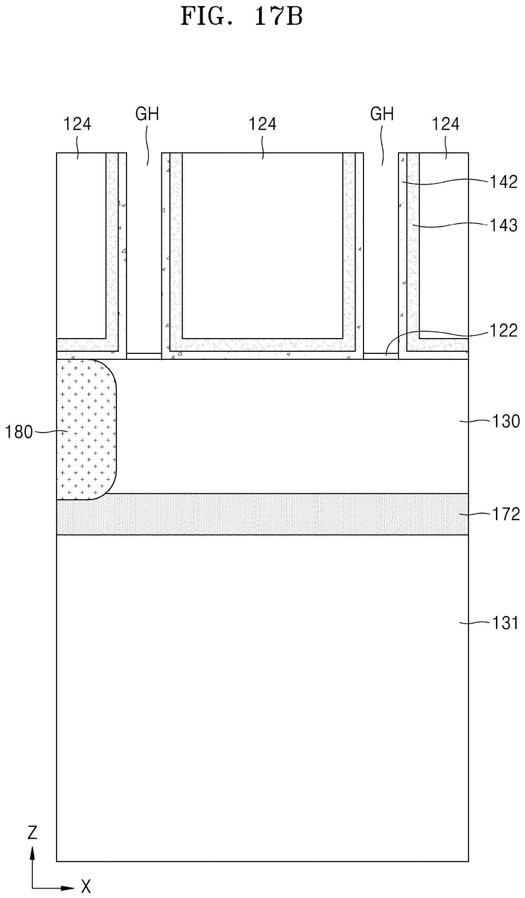

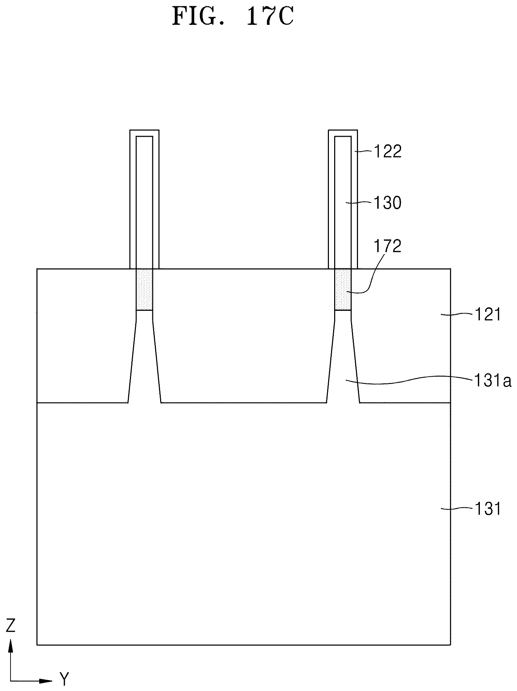

Referring to FIG. 17A, a structure may be provided in which the dummy gates 152 are removed and gate holes GH for forming gate electrodes are formed. FIGS. 17B and 17C are cross-sectional views respectively taken along lines BB and CC of FIG. 17A.

Although it is illustrated that the dielectric layer 122 surrounding the three surfaces of each of the channel structures 130 remains, the dielectric layer 122 may be removed or thinned. The portion of the dielectric layer 122 remaining on the channel structures 130 may form portions of a gate insulating layer.

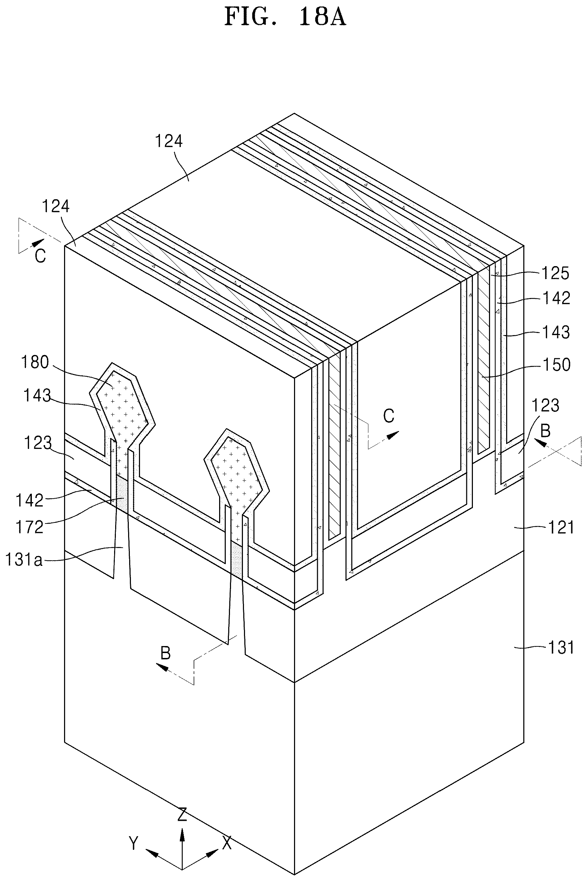

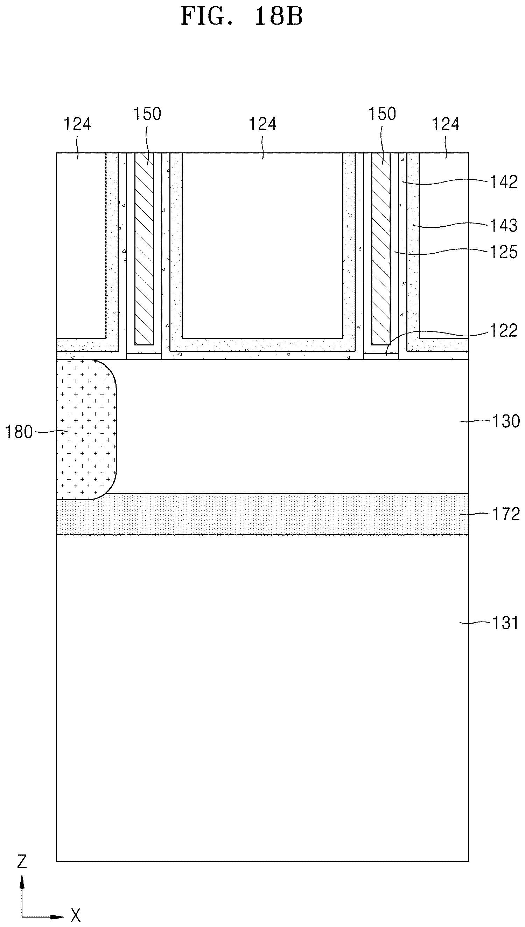

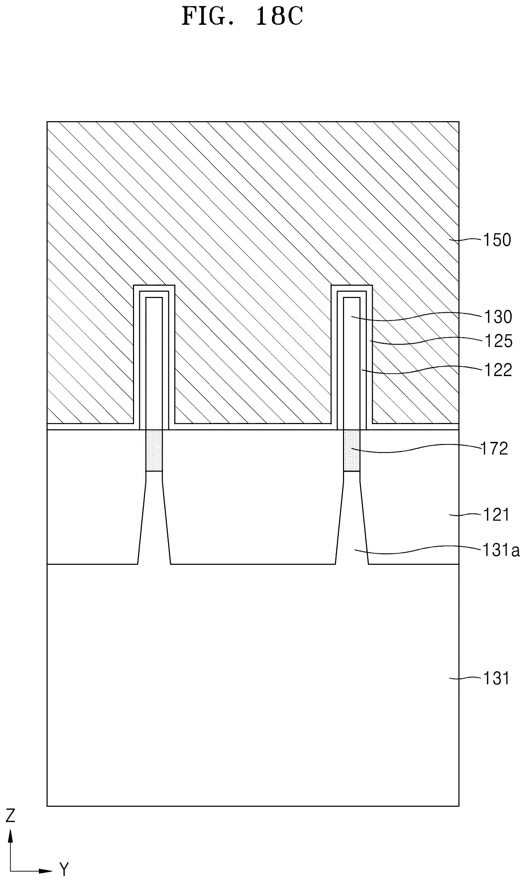

Referring to FIG. 18A, a structure may be provided in which gate electrodes 150 are formed. FIGS. 18B and 18C are cross-sectional views respectively taken along lines BB and CC of FIG. 18A.

Before forming the gate electrode 150, a gate insulating layer 125 may first be deposited along inner walls of the gate holes GH, and then, the gate electrodes 150 may be formed. The gate insulating layer 125 may include, for example, HfO₂. However, embodiments are not limited thereto, and the gate insulating layer 125 may include silicon oxide (SiO₂), silicon nitride (SiN), aluminum oxide (Al₂O₃), titanium oxide (TiO₂), or zirconium oxide (ZrO₂). The remaining portion of the dielectric layer 122 may serve as a gate insulating film together with the gate insulating layer 125. The gate electrodes 150 may include a conductive material such as a metal, a metal nitride, a metal carbide, or polysilicon. The gate electrodes 150 may include, for example, TiN, TiAlC, or TiAlN. The gate insulating layer 125 and the gate electrodes 150 may be formed by, for example, an atomic layer deposition (ALD) method. However, embodiments are not limited thereto, and the gate insulating layer 125 and the gate electrodes 150 may also be formed by other methods such as chemical vapor deposition (CVD) or sputtering.

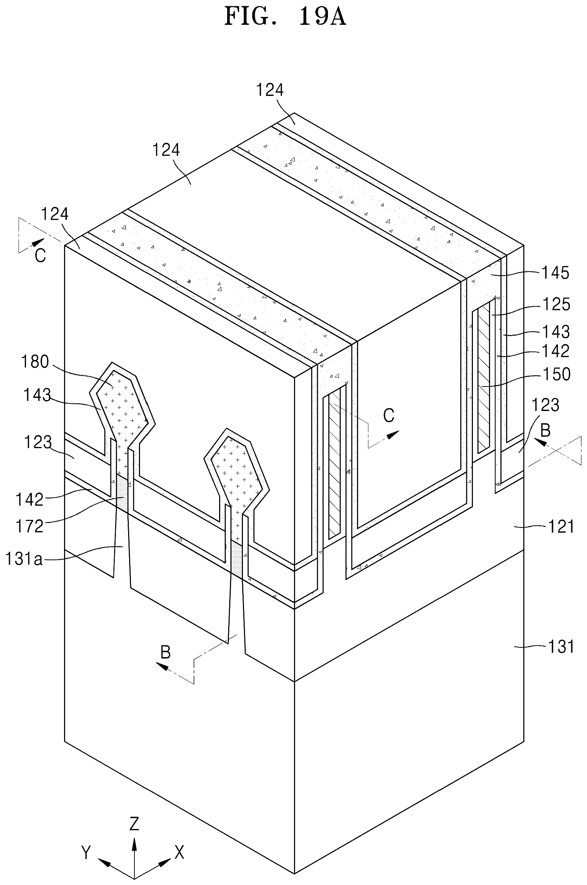

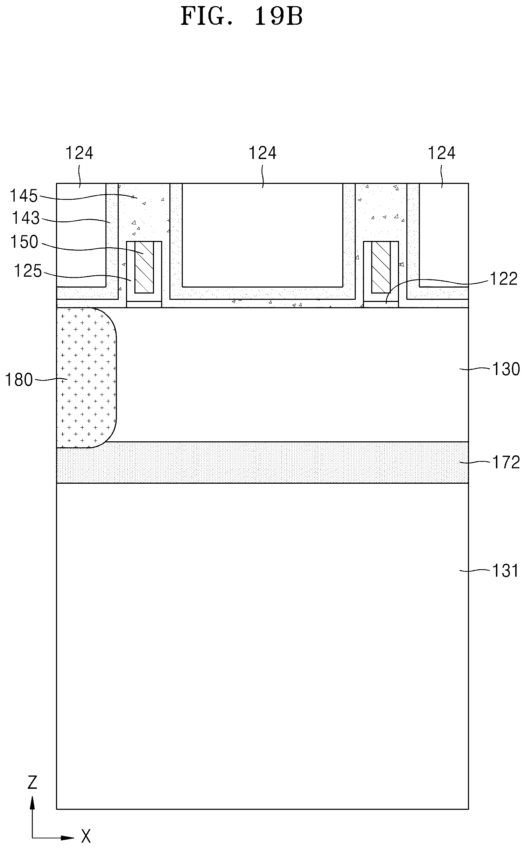

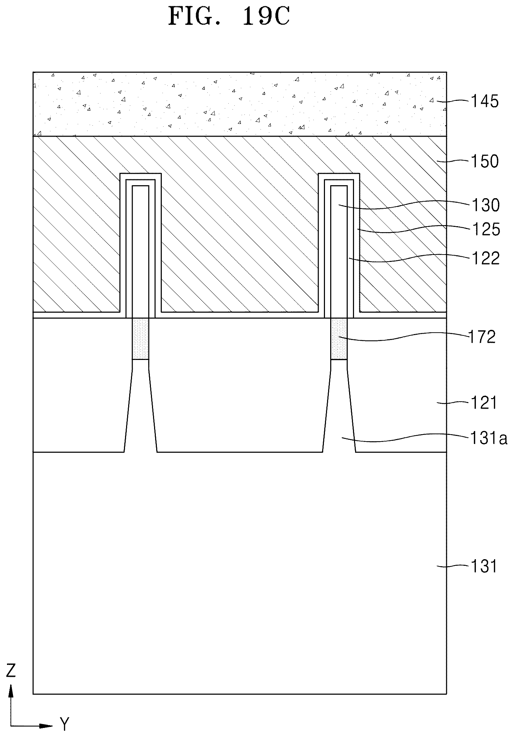

Referring to FIG. 19A, a structure may be provided in which upper portions of the gate electrodes 150 and adjacent portions of the gate insulating layer 125 and the dielectric layer 142 are removed from the structure shown in FIG. 18A, and a dielectric layer 145 is filled in the removed portions. FIGS. 19B and 19C are cross-sectional views respectively taken along lines BB and CC of FIG. 19A.

In this process, filling with the dielectric layer 145 may be omitted. In other words, the process may be finished after reducing the height of the gate electrodes 150.

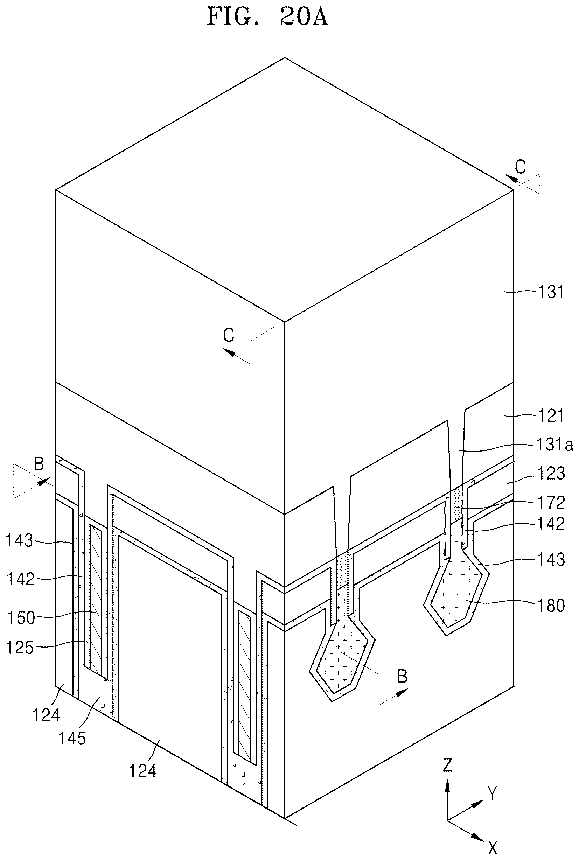

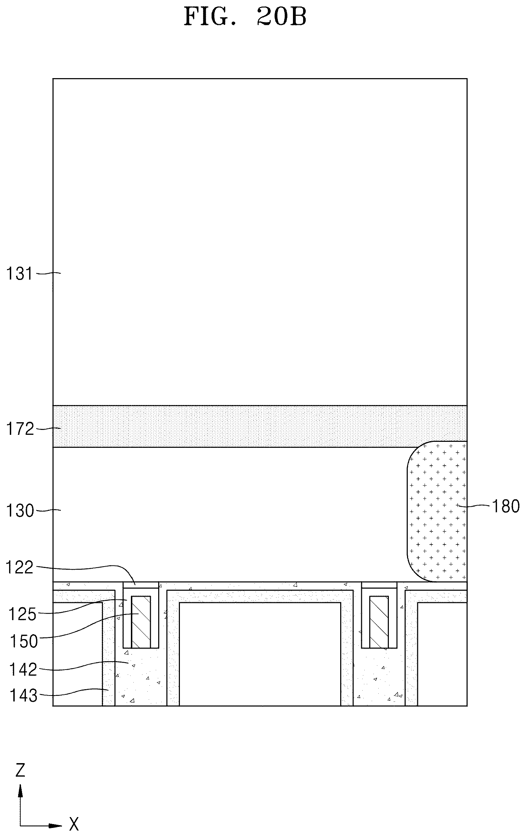

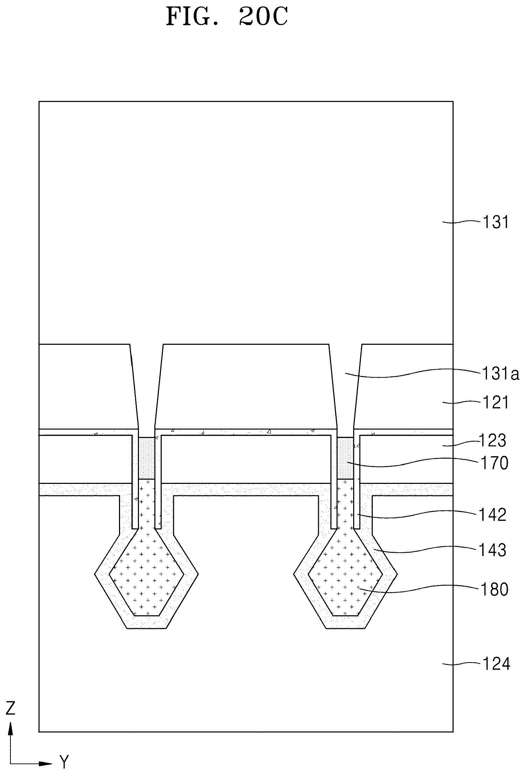

Referring to FIG. 20A, a structure may be provided in which the structure shown in FIG. 19A is flipped upside down (backside up) for a backside process. According to some embodiments, this process may be performed after attaching the structure shown in FIG. 19A to a carrier wafer. FIGS. 20B and 20C are cross-sectional views respectively taken along lines BB and CC of FIG. 20A.

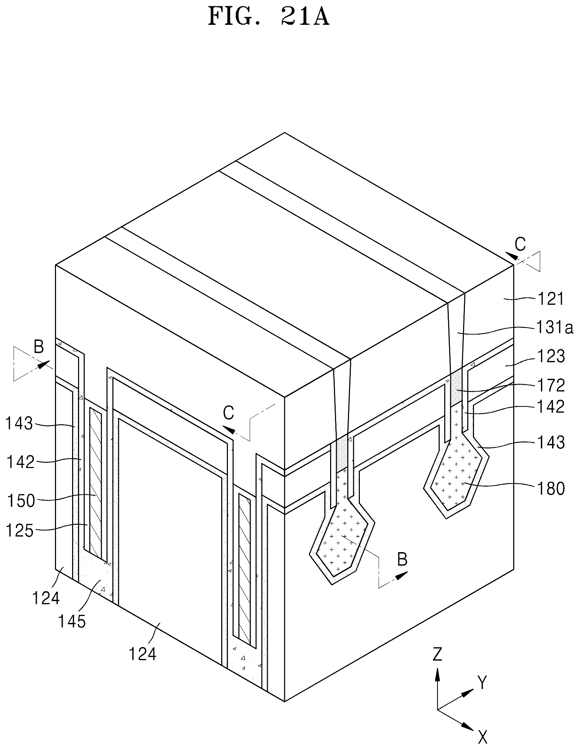

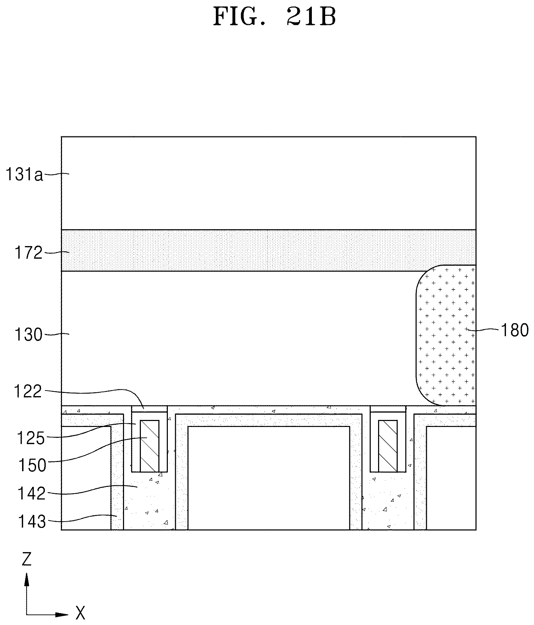

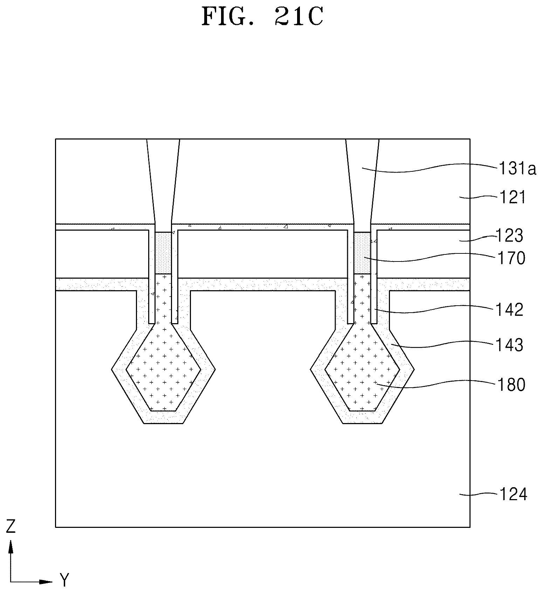

Referring to FIG. 21A, a structure may be provided in which most of the first semiconductor layer 131 is etched away from the structure shown in FIG. 20A. FIGS. 21B and 21C are cross-sectional views respectively taken along lines BB and CC of FIG. 21A.

The process of etching the first semiconductor layer 131 may be performed until the isolation layer 121 is exposed. That is, a bulk semiconductor portion of the first semiconductor layer 131 may be entirely etched, and only a portion of the first semiconductor layer patterned corresponding to the channel structures 130, referred to as the first semiconductor layers 131a, may remain.

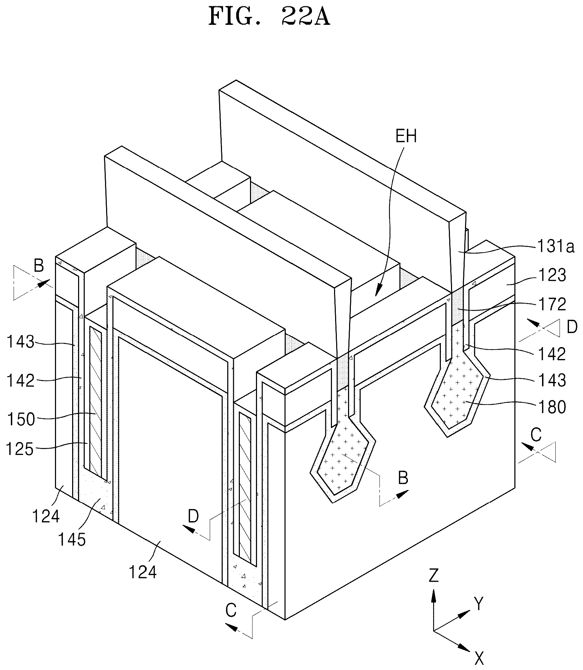

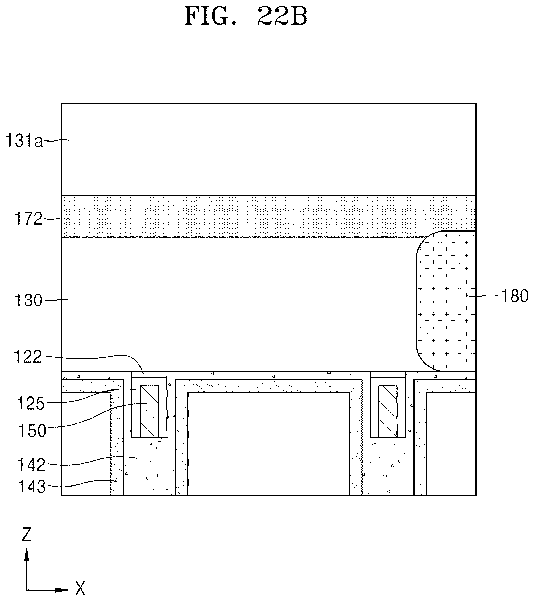

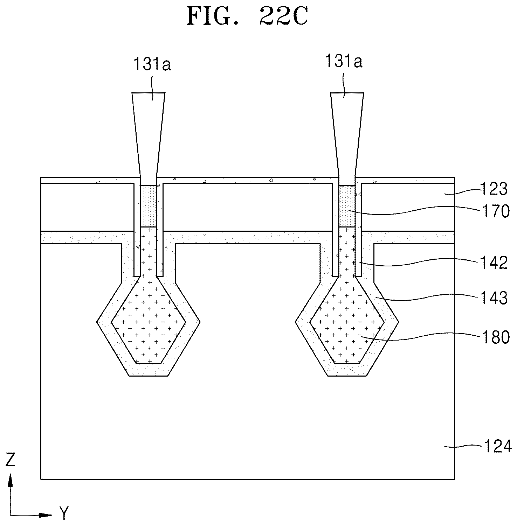

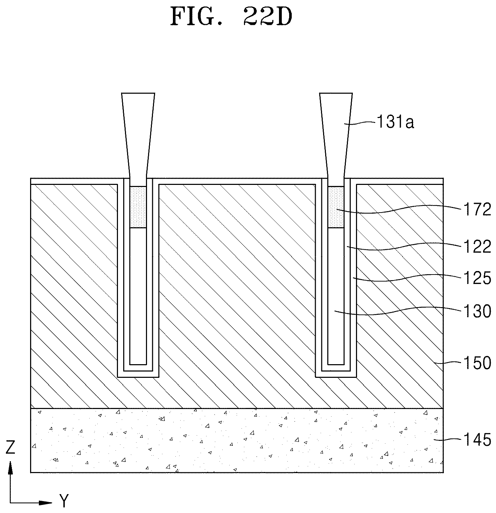

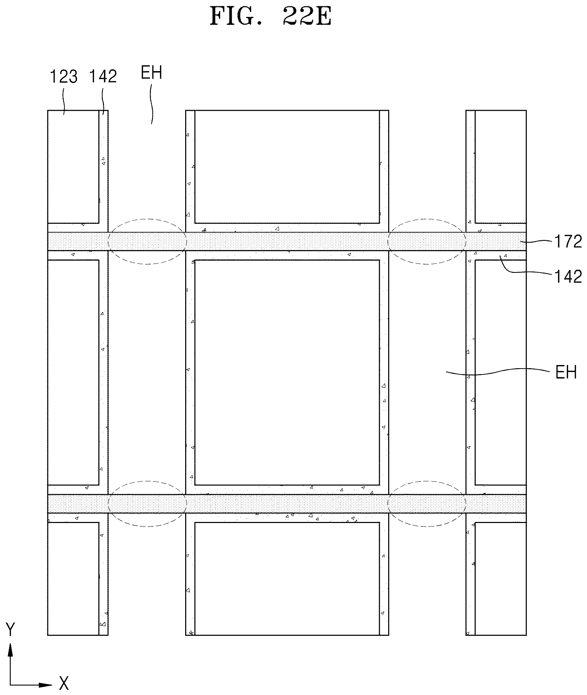

Referring to FIG. 22A, a structure may be provided in which the isolation layer 121 is removed. FIGS. 22B, 22C, and 22D are cross-sectional views respectively taken along lines BB, CC, and DD of FIG. 22A. FIG. 22E is a plan view illustrating lower sides of the first semiconductor layers 131a shown in FIG. 22A. In FIG. 22E, illustration of the first semiconductor layers 131a is omitted.

Referring to FIG. 22A together with FIG. 21A, because the isolation layer 121 is selectively removed from the structure shown in FIG. 21A, etching holes EH for etching the sacrificial material layer 172 in a subsequent process may be formed. The dielectric layer 142, which has a lower etch rate than an etch rate of the isolation layer 121, may serve as an etch stop layer in the substrate process.

Referring to FIG. 22E, the sacrificial material layer 172 may include portions exposed to the etching holes EH and portions not exposed to the etching holes EH. Portions indicated by dashed ellipses refer to the portions of the sacrificial material layer 172 that are exposed to the etching holes EH.

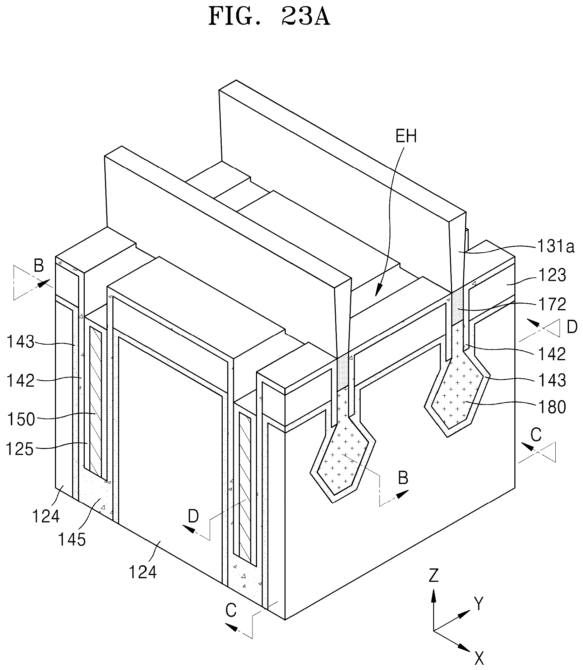

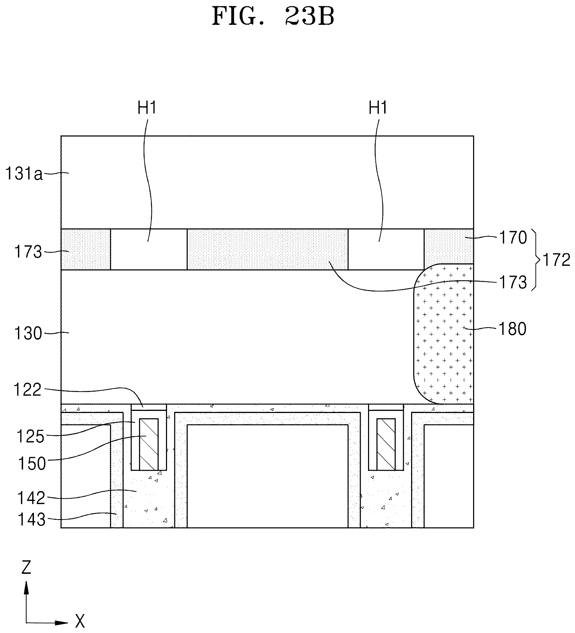

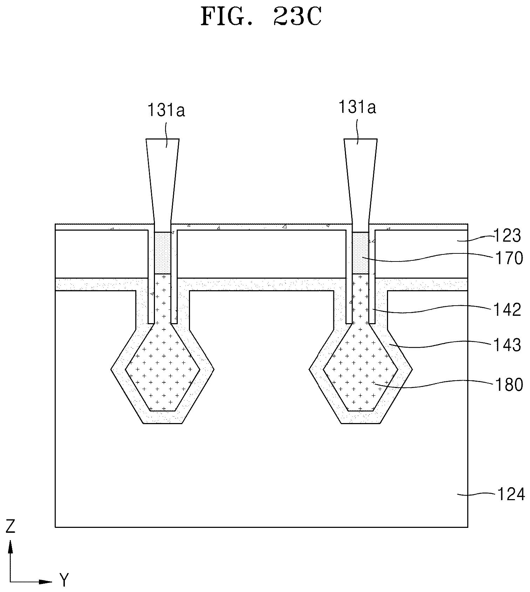

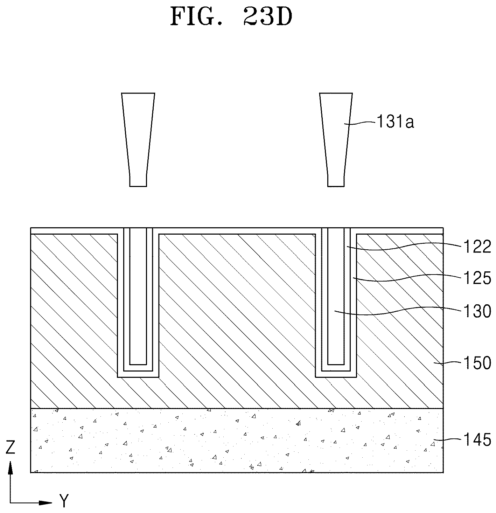

Referring to FIG. 23A, a structure may be provided in which the portions of the sacrificial material layer 172 exposed to the etching holes EH are removed through an etching process. FIGS. 23B, 23C, and 23D are cross-sectional views respectively taken along lines BB, CC, and DD of FIG. 23A.

In FIG. 23B, spaces H1 may be provided from which the exposed portions of the sacrificial material layer 172 are removed. The spaces H1 may be located at positions facing channels. Here, the channels may be defined as regions of the channel structures 130 at which the channel structures 130 cross the gate electrodes 150. However, the width of the spaces H1 is not limited to being the same as the width of the channels defined as described above. Hereinafter, portions of the sacrificial material layer 172 that are located on the source/drain structures 180 may be referred to as sacrificial structures 170, and the remaining portions of the sacrificial material layer 172 may be referred to as residual sacrificial patterns 173.

Referring to FIG. 23B, the residual sacrificial patterns 173 may alternate with the spaces H1 in the second direction (e.g., X-direction). The width of the residual sacrificial patterns 173 shown in FIG. 23B is only an example, and embodiments are not limited thereto. Depending on the spacing of the gate electrodes 150 arranged in the second direction (e.g., X-direction), the width of the residual sacrificial patterns 173 may be reduced, or substantially no residual sacrificial patterns 173 may remain.

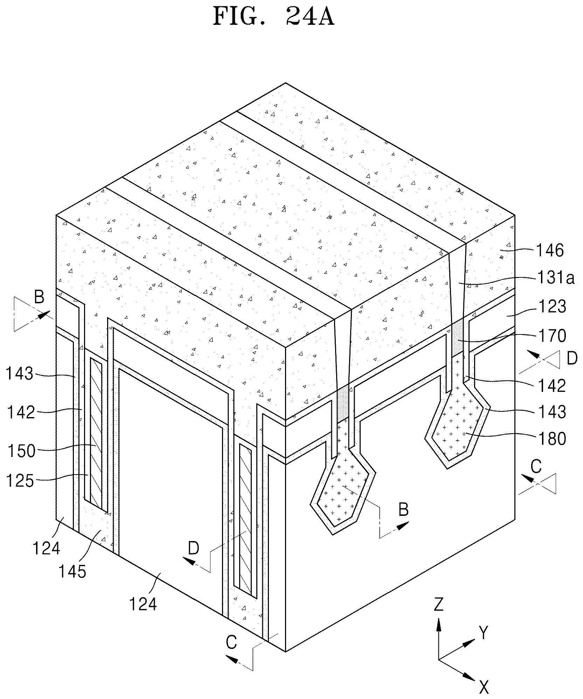

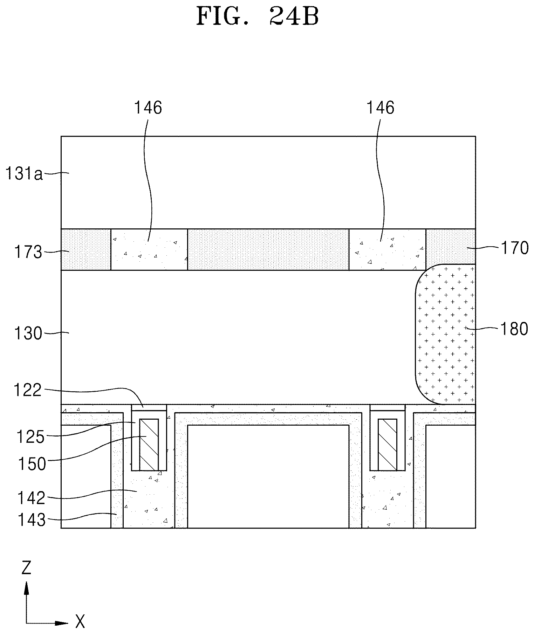

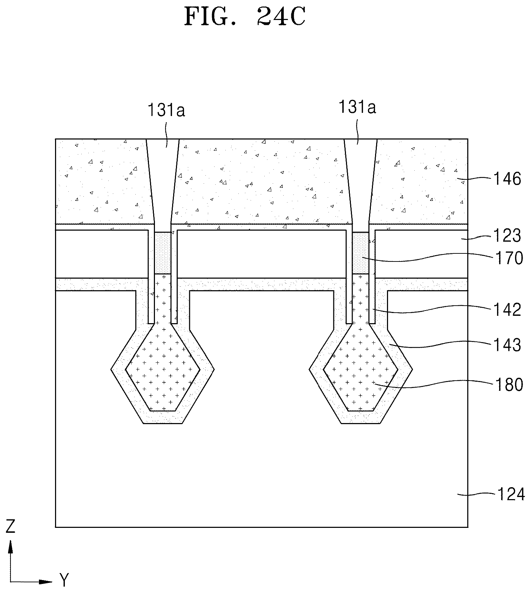

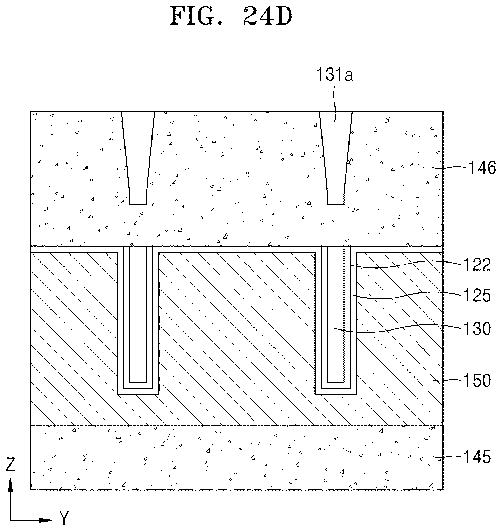

Referring to FIG. 24A, a structure may be provided in which the structure shown in FIG. 23A is covered with a dielectric layer 146. FIGS. 24B, 24C, and 24D are cross-sectional views respectively taken along lines BB, CC, and DD of FIG. 24A.

The dielectric layer 146 may be formed to a height at which upper surfaces of the first semiconductor layers 131a are exposed. For example, after forming the dielectric layer 146 to a thickness that fully covers the first semiconductor layers 131a, a planarization process may be performed to expose the upper surfaces of the first semiconductor layers 131a. The dielectric layer 146 may include the same material as the dielectric layer 142.

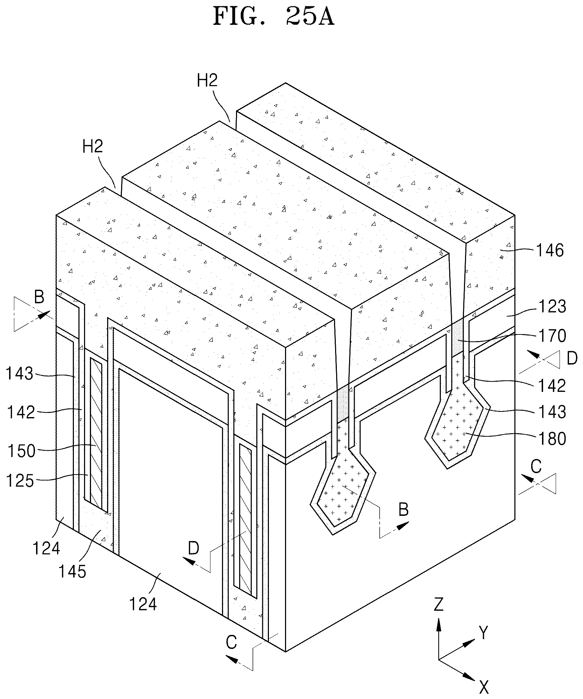

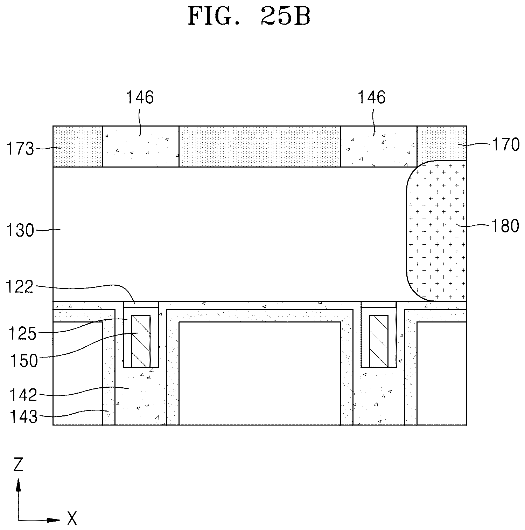

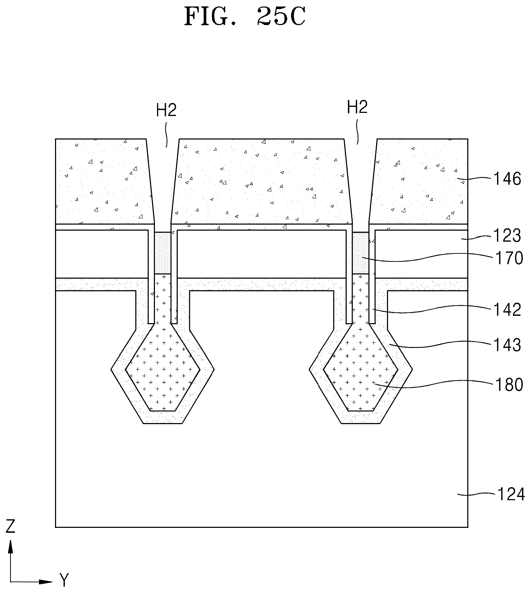

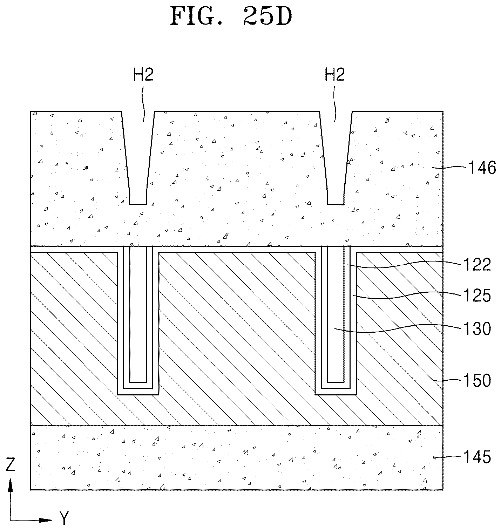

Referring to FIG. 25A, a structure may be provided in which spaces H2 are formed by removing the first semiconductor layers 131a from the structure shown in FIG. 24A.

The first semiconductor layers 131a may have a different etch selectivity from the dielectric layer 146 and the sacrificial structures 170. That is, only the first semiconductor layers 131a may be selectively etched.

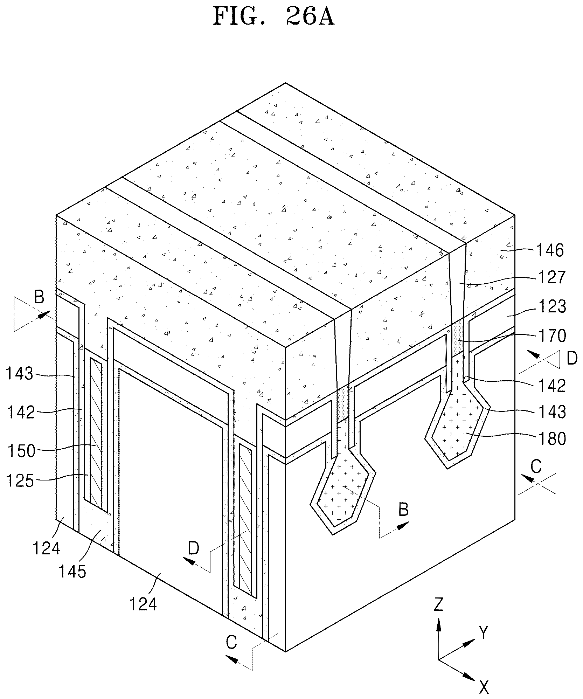

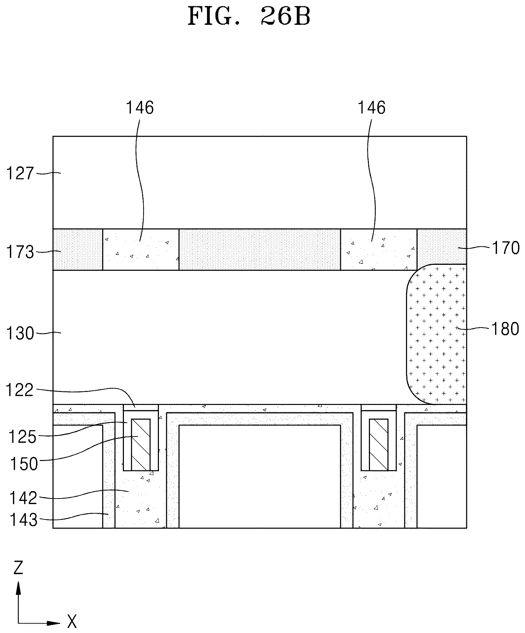

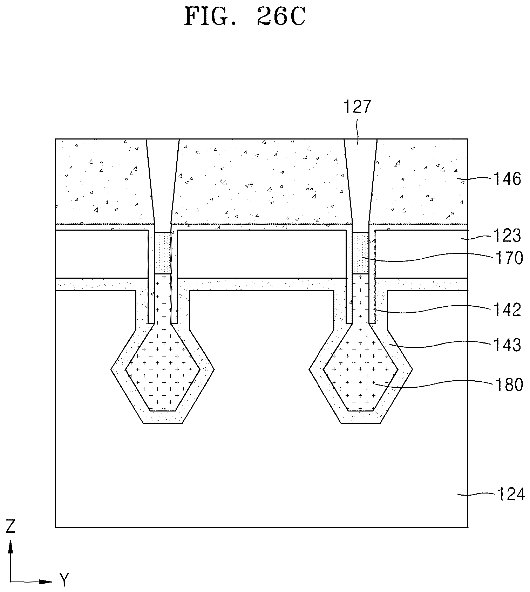

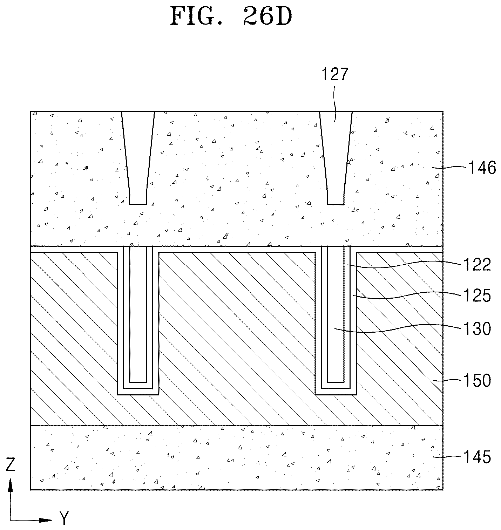

Referring to FIG. 26A, a structure may be provided in which the spaces H2 shown in FIG. 25A are filled with a dielectric layer 127. FIGS. 26B, 26C, and 26D are cross-sectional views respectively taken along lines BB, CC, and DD of FIG. 26A.

After forming the dielectric layer 127 to fill the spaces H2 shown in FIG. 25A and cover the upper surface of the dielectric layer 146, a planarization process may be performed to a depth at which the dielectric layer 146 is exposed. The dielectric layer 127 may include the same material as the dielectric layer 123 or the dielectric layer 124.

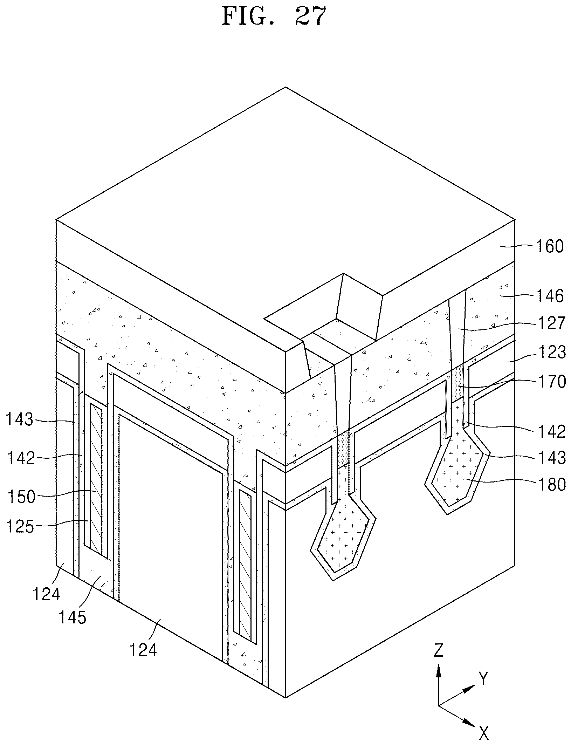

Referring to FIG. 27, a structure may be provided in which a mask 160 for forming a back contact electrode is disposed on the structure shown in FIG. 26A.

The mask 160 may have a shape that exposes the dielectric layer 127 at a position corresponding to a source/drain structure 180 that is to be connected to a back contact electrode. Through an etching process using the mask 160, the dielectric layer 127 and a sacrificial structure 170 that are provided on the source/drain structure 180 to be connected to a back contact electrode may be etched.

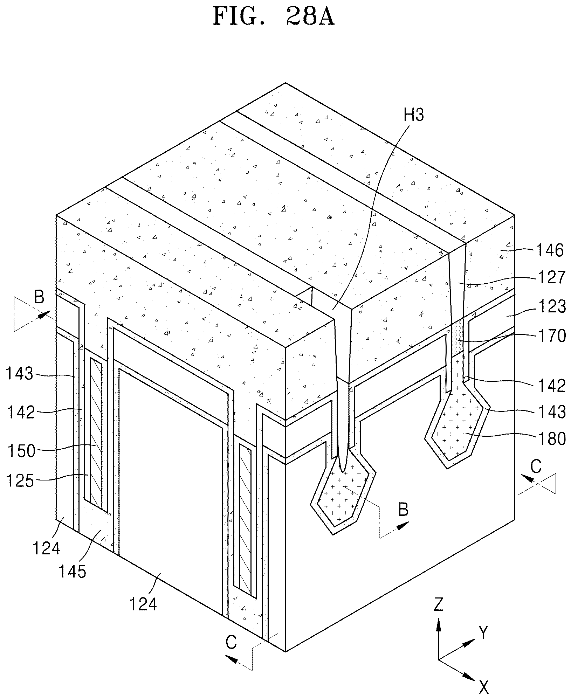

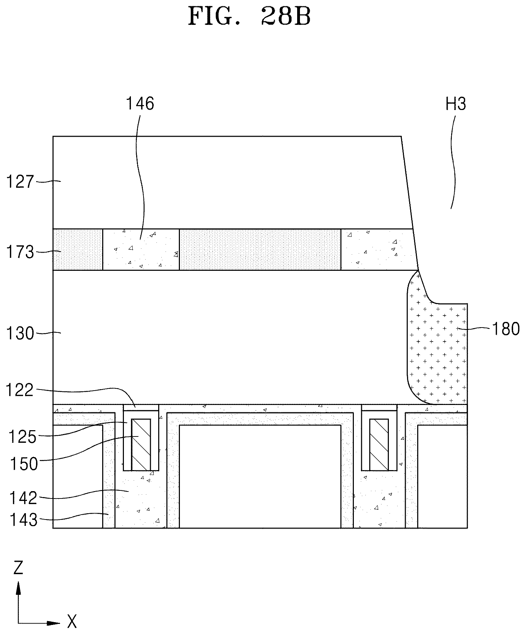

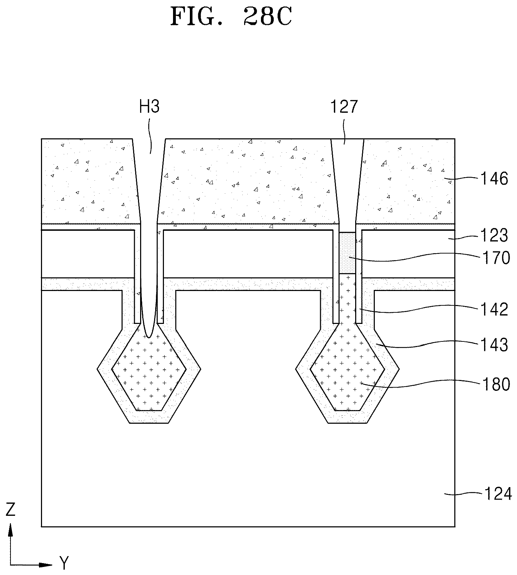

Referring to FIG. 28A, a structure may be provided in which a space H3 is formed to expose the source/drain structure 180 that is to be connected to a back contact electrode. FIGS. 28B, 28C, and 28D are cross-sectional views respectively taken along lines BB, CC, and DD of FIG. 28A.

In an etching process for forming the space H3, the sacrificial structure 170 provided on the source/drain structure 180 to be connected to a back contact electrode may be completely removed, and the source/drain structure 180 may be partially etched.

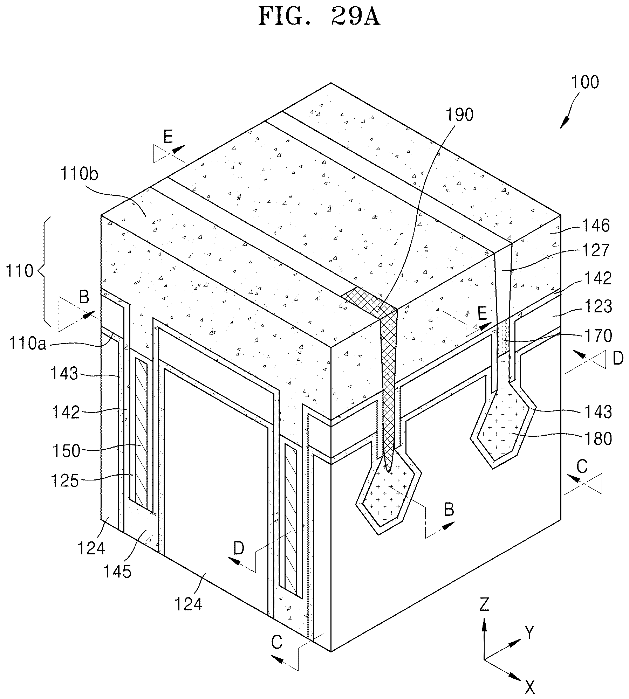

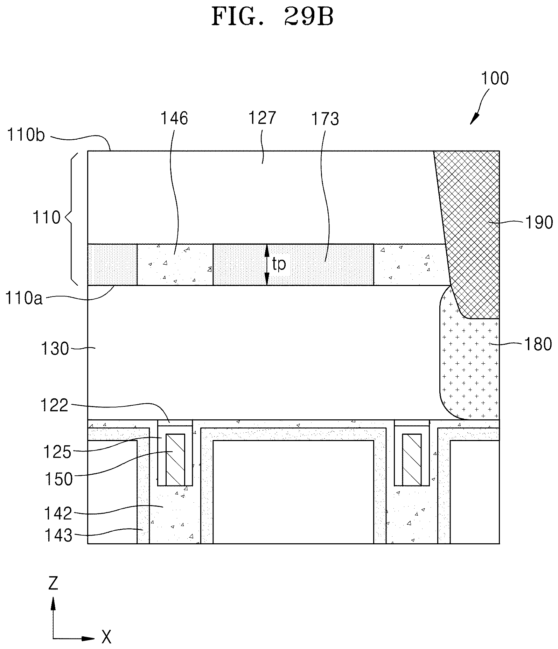

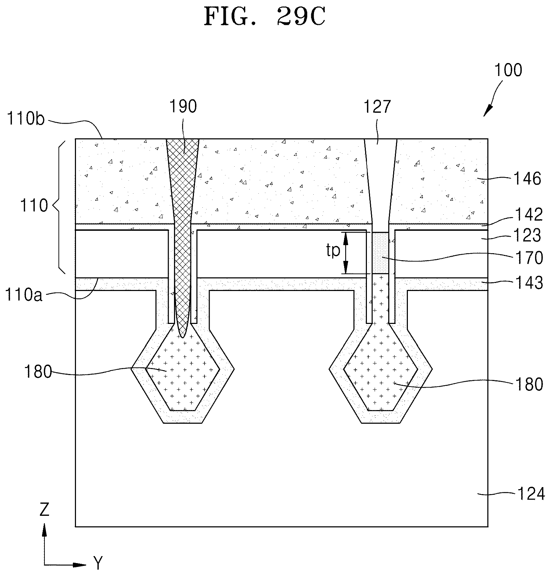

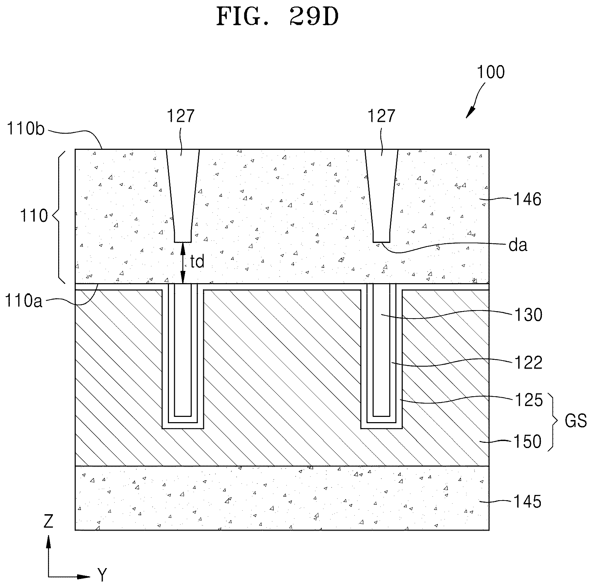

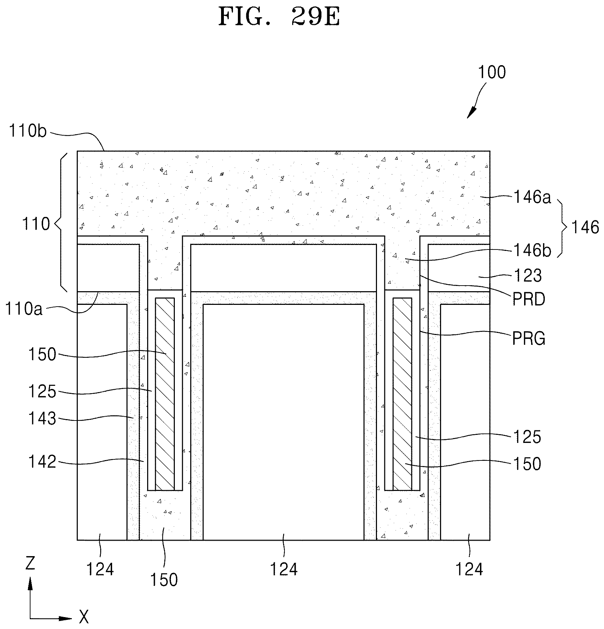

Referring to FIG. 29A, a semiconductor device 100 having a structure in which a back contact electrode 190 is connected to a source/drain structure 180 may be provided. FIGS. 29B, 29C, 29D, and 29E are cross-sectional views respectively taken along lines BB, CC, DD, and EE of FIG. 29A.

A structure of the semiconductor device 100 manufactured as described above is described below with reference to FIGS. 29A to 20E.

A support structure layer 110 may include a plurality of types of dielectric materials. In addition, the support structure layer 110 may include a first surface 110a and a second surface 110b. Although FIG. 29A shows the back contact electrode 190 of the semiconductor device 100 at the top for ease of illustration, the first surface 110a may refer to an upper surface, and the second surface 110b may refer to a back surface.

The channel structures 130 may be formed on the first surface 110a. The channel structures 130 may protrude in a direction away from the support structure layer 110 and may be arranged apart from each other in the first direction (e.g., Y-direction) parallel to the first surface 110a.

The source/drain structures 180 may be formed on the first surface 110a of the support structure layer 110 at both ends of each of the channel structures 130. In FIGS. 29A to 29E, only the source/drain structures 180, each disposed on one end of each of the channel structures 130, are illustrated.

The gate electrodes 150 may be arranged apart from each other on the first surface 110a of the support structure layer 110 in the second direction (e.g., X-direction), which is different from the first direction and parallel to the first surface 110a. The gate electrodes 150 may surround three surfaces of each of the channel structures 130 at different positions in the second direction. The gate insulating layer 125 may be provided between the channel structures 130 and the gate electrodes 150, and structures including the gate electrodes 150 and the gate insulating layer 125 may be referred to as gate structures GS.

Some of the source/drain structures 180 may be connected to back contact electrodes 190, which may be formed to penetrate the support structure layer 110 and are exposed on the second surface 110b (e.g., back surface) of the support structure layer 110.

The remaining source/drain structures 180, which are not connected to the back contact electrodes 190, may be connected to the sacrificial structures 170 provided within the support structure layer 110.

As described previously in the description of the manufacturing method, the support structure layer 110 may include a plurality of types of dielectric materials having different etch rates from each other. In the following description, the dielectric layer 127 may be referred to as a first dielectric layer, and the dielectric layer 146 is referred to as a second dielectric layer. The dielectric layer 127 (e.g., the first dielectric layer) may include silicon oxide, and the dielectric layer 146 (e.g., the second dielectric layer) may include silicon nitride, silicon oxynitride, silicon carbonitride, or silicon carbon oxynitride.

A plurality of material layers including the dielectric layer 127 (e.g., the first dielectric layer) and the dielectric layer 146 (e.g., the second dielectric layer) may be formed in the support structure layer 110, and a configuration of the support structure layer 110 is described below.

The dielectric layer 127 (e.g., the first dielectric layer) may include a plurality of regions arranged apart from each other and each facing the one of the channel structures 130. Like the channel structures 130, the regions of the dielectric layer 127 (e.g., the first dielectric layer) may also be arranged in the first direction (e.g., Y-direction). Each of the regions of the dielectric layer 127 (e.g., the first dielectric layer) may have a shape extending into the support structure layer 110 from the second surface 110b of the support structure layer 110, and as shown in FIG. 29D, end portions da of the regions may be at the same depth within the support structure layer 110.

The dielectric layer 146 (e.g., the second dielectric layer) may be disposed between the dielectric layer 127 (e.g., the first dielectric layer) and the channel structures 130, and the thickness td of the dielectric layer 146 (e.g., the second dielectric layer), directly below the channel structures 130, may be equal to the thickness tp of the sacrificial structures 170. The thickness of the sacrificial structures 170 may not uniform.. As described above, this is because a portion of the sacrificial structures 170 may be etched during a process of forming the source/drain structures 180. In other words, the thickness td of the dielectric layer 146 (e.g., the second dielectric layer), directly below the channel structure 130, may be different from the thickness tp of the sacrificial structures 170, or may be substantially equal to the thickness of a thickest portion of the sacrificial structures 170.

As shown in FIG. 29B, the residual sacrificial patterns 173 including the same material as the sacrificial structures 170 may remain between the channel structures 130 and the first dielectric layer 127. The thickness tp of the residual sacrificial patterns 173 may also be the same as the thickness tp of the sacrificial structures 170. The residual sacrificial patterns 173 may be remaining patterns that were not removed when the sacrificial material layer 172 exposed through the etching holes EH was removed, as described with reference to FIGS. 22A to 22E. Therefore, the residual sacrificial patterns 173 may not remain at positions at which the etching holes EH were present, that is, at positions facing the gate electrodes 150, and thus, the positions are in the region of the dielectric layer 146 (e.g., the second dielectric layer). When viewed in a direction perpendicular to the first surface 110a of the support structure layer 110, the residual sacrificial patterns 173 may not overlap the gate electrodes 150. Regions of the dielectric layer 146 (e.g., the second dielectric layer) and the residual sacrificial patterns 173 may be alternately arranged in the second direction (e.g., X-direction) between the first dielectric layer 127 and the channel structures 130. In other words, the dielectric layer 146 (e.g., the second dielectric layer) may face the gate structures GS, and the residual sacrificial patterns 173 may face regions between the gate structures GS. Here, the gate structures GS may be structures including the gate electrodes 150 and the gate insulating layer 125.

Referring to FIG. 29E, which is a cross-sectional view taken along the line EE that does not pass through the channel structures 130, the dielectric layer 146 (e.g., the second dielectric layer) may include a first region 146a that extends to a thickness position from the second surface 110b of the support structure layer 110 toward the first surface 110a of the support structure layer 110, and a plurality of second regions 146b that protrude from this thickness position to the second surface 110b. The second regions 146b face the gate structures GS in a one-to-one manner. A lateral surface profile PRD of the second regions 146b may be the same as a lateral surface profile PRG of the gate structures GS. However, the width of the second regions 146b is not limited to being the same as the width of the gate structures GS. The lateral surface profile PRD of the second regions 146b and the lateral surface profile PRG of the gate structures GS may result from the patterning of the isolation layer 121, in which the dielectric layer 141 used as a hard mask for patterning the dummy gates 152 is used as a mask to pattern the isolation layer 121 as described with reference to FIG. 9A. In the semiconductor device 100 completely manufactured, the lateral surface profile PRG of the gate structure GS may be continuous with the lateral surface profile PRD of the second regions 146b of the dielectric layer 146 (e.g., the second dielectric layer), like the lateral surface profile PRG of the dummy gates 152 being continuous with the lateral surface profile PRD of the protruding portions of the isolation layer 121 as shown in FIG. 9A.

The dielectric layer 123 may be positioned on both sides of each of the second regions 146b. The dielectric layer 123 may be referred to as a third dielectric layer. The dielectric layer 123 (e.g., the third dielectric layer) may include a material that is different from a material included in the dielectric layer 127 (e.g., the first dielectric layer) or the dielectric layer 146 (e.g., the second dielectric layer). Alternatively, the dielectric layer 123 (e.g., the third dielectric layer) may include the same material as the dielectric layer 127 (e.g., the first dielectric layer).

The dielectric layer 142 may be located between the dielectric layer 146 (e.g., the second dielectric layer) and the dielectric layer 123 (e.g., the third dielectric layer). The dielectric layer 142 may be referred to as a fourth dielectric layer. The dielectric layer 142 (e.g., the fourth dielectric layer) may be conformally formed along the shape of the dielectric layer 146 (e.g., the second dielectric layer). The dielectric layer 142 (e.g., the fourth dielectric layer) may extend along lateral surfaces of the gate structures GS from lateral surfaces of the second regions 146b. The dielectric layer (e.g., the fourth dielectric layer) may include the same material as the dielectric layer 146 (e.g., the second dielectric layer).

The dielectric layer 143 may be further formed on the first surface 110a of the support structure layer 110 and may have a shape surrounding the source/drain structures 180. The dielectric layer 143 may extend along the lateral surfaces of the gate structures GS. The dielectric layer 124 may be formed in the remaining regions on the support structure layer 110. The dielectric layer 124 may include the same material as the dielectric layer 127 or the dielectric layer 123. However, embodiments are not limited thereto.

The semiconductor devices 10 and 100 of the embodiments, including the semiconductor device 100 formed by the manufacturing method of the embodiment, may have ultra-small sizes and high electrical performance and may thus be applied to integrated circuit devices. The semiconductor devices 10 and 100 of the embodiments may serve as logic transistors and be used in various electronic apparatuses together with controllers that control the logic transistors.

The semiconductor devices 10 and 100 may be used in, for example, display driver integrated circuits (display driver ICs or DDIs), complementary metal-oxide-semiconductor (CMOS) inverters, CMOS static random-access memory (SRAM) devices, CMOS NAND circuits, and/or various other electronic apparatuses.

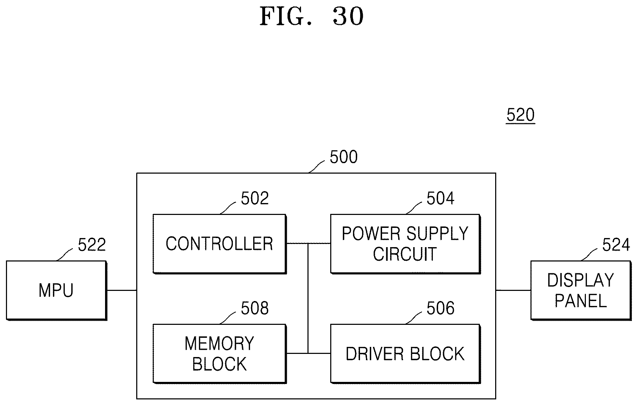

FIG. 30 is a block diagram schematically illustrating a display apparatus 520 including a DDI 500 according to an embodiment.

Referring to FIG. 30, the DDI 500 may include a controller 502, a power supply circuit 504, a driver block 506, and a memory block 508. The controller 502 may receive and decode instructions from a main processing unit (MPU) 522 and controls each block of the DDI 500 to perform operations according to the instructions. The power supply circuit 504 may generate driving voltages in response to control by the controller 502. The driver block 506 may drive a display panel 524 by using the driving voltages generated by the power supply circuit 504 in response to control by the controller 502. The display panel 524 may include, for example, a liquid crystal display (LCD) panel, an organic light emitting device (OLED) display panel, or a plasma display panel. The memory block 508 may temporarily store instructions input to the controller 502, control signals output from the controller 502, or other data. The memory block 508 may include memory such as random-access memory (RAM) or read-only memory (ROM). The power supply circuit 504 and the driver block 506 may include one of the semiconductor devices 10 and 200 of the embodiments described above, or a combination of modifications of the semiconductor devices 10 and 100.

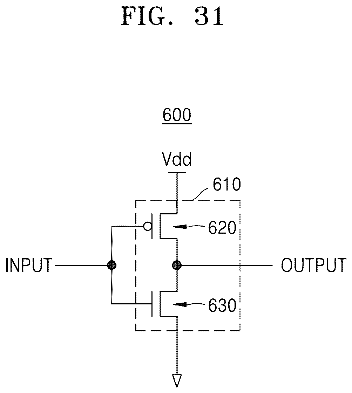

FIG. 31 is a circuit diagram illustrating a CMOS inverter 600 according to an embodiment.

Referring to FIG. 31, the CMOS inverter 600 may include a CMOS transistor 610. The CMOS transistor 610 may include a p-channel metal-oxide semiconductor (PMOS) transistor 620 and an n-channel metal-oxide semiconductor (NMOS) transistor 630 that are connected between a power supply terminal Vdd and a ground terminal. The CMOS transistor 610 may include one of the semiconductor devices 10 and 100 of the embodiments described above, or a combination of modifications of the semiconductor devices 10 and 100.

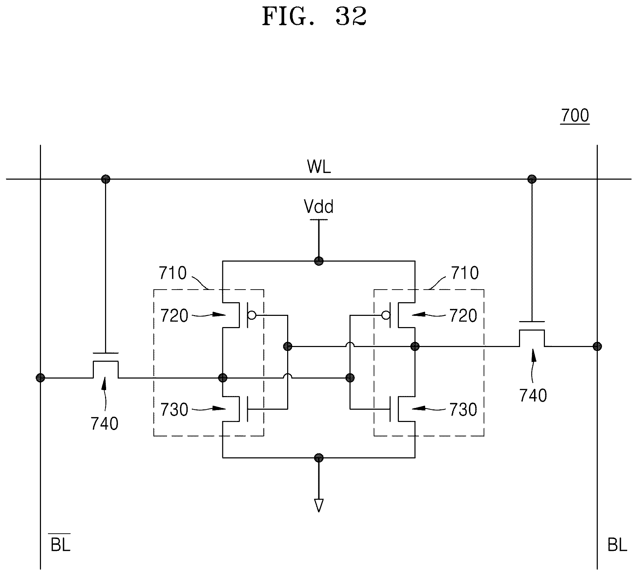

FIG. 32 is a circuit diagram illustrating a CMOS SRAM device 700 according to an embodiment.

Referring to 32, the CMOS SRAM device 700 may include a pair of driving transistors 710. Each of the pair of driving transistors 710 may include a PMOS transistor 720 and an NMOS transistor 730 that are connected between a power supply terminal Vdd and a ground terminal. The CMOS SRAM device 700 may further include a pair of transfer transistors 740. A source of each of the pair of transfer transistors 740 may be cross-connected to a common node of the PMOS transistor 720 and the NMOS transistor 730 of each of the pair of driving transistors 710. A source of the PMOS transistor 720 may be connected to the power supply terminal Vdd, and a source of the NMOS transistor 730 may be connected to the ground terminal. Gates of the pair of transfer transistors 740 may be connected to a word line WL, and drains of the pair of transfer transistors 740 may be respectively connected to a bit line BL and an inverted bit line. At least one of the pair of driving transistors 710 and the pair of transfer transistors 740 of the CMOS SRAM device 700 may include one of the semiconductor devices 10 and 100 of the embodiments described above, or a combination of modifications of the semiconductor devices 10 and 100.

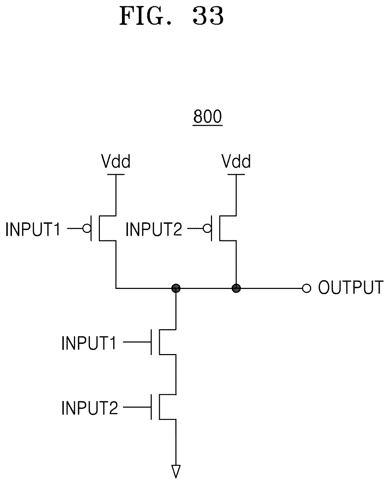

FIG. 33 is a circuit diagram of a CMOS NAND circuit 800 according to an embodiment.

Referring to 33, the CMOS NAND circuit 800 may include a pair of CMOS transistors receiving different input signals. The CMOS NAND circuit 800 may include one of the semiconductor devices 10 and 100 of the embodiments described above, or a combination of modifications of the semiconductor devices 10 and 100.

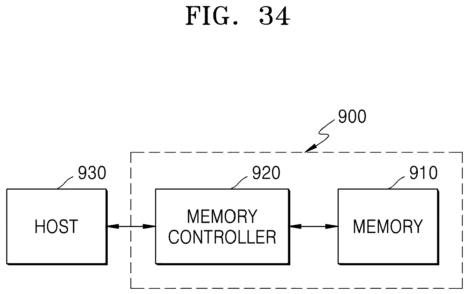

FIG. 34 is a block diagram illustrating an electronic apparatus 900 according to an embodiment.

Referring to 34, the electronic apparatus 900 may include memory 910 and a memory controller 920. The memory controller 920 may control the memory 910 to read data from and/or write data to the memory 910 in response to requests from a host 930. At least one of the memory 910 and the memory controller 920 may include one of the semiconductor devices 10 and 100 of the embodiments described above, or a combination of modifications of the semiconductor devices 10 and 100.

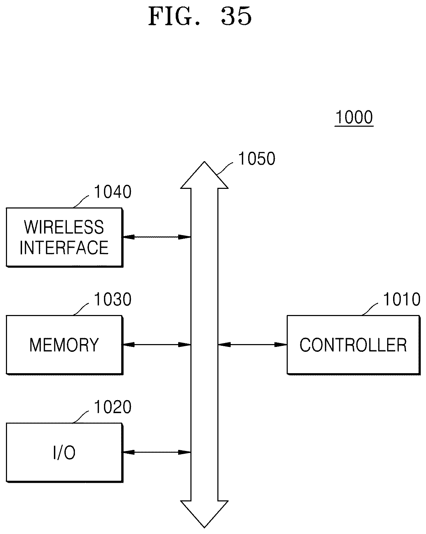

FIG. 35 is a block diagram illustrating an electronic apparatus 1000 according to an embodiment.

Referring to FIG. 35, the electronic apparatus 1000 may form a wireless communication device or a device capable of transmitting and/or receiving information in a wireless environment. The electronic apparatus 1000 may include a controller 1010, an input/output (I/O) device 1020, memory 1030, and a wireless interface 1040 that are connected to each other via a bus 1050.

The controller 1010 may include at least one from among a microprocessor, a digital signal processor, and a similar processing device. The I/O device 1020 may include at least one from among a keypad, a keyboard, and a display. The memory 1030 may store instructions executed by the controller 1010. For example, the memory 1030 may store user data. The electronic apparatus 1000 may use the wireless interface 1040 to transmit/receive data over a wireless communication network. The wireless interface 1040 may include an antenna and/or a wireless transceiver. In some embodiments, the electronic apparatus 1000 may be used with communication interface protocols of third-generation communication systems such as code division multiple access (CDMA), global system for mobile communications (GSM), North American digital cellular (NADC), extended-time division multiple access (E-TDMA), and/or wideband code division multiple access (WCDMA). The electronic apparatus 1000 may include one of the semiconductor devices 10 and 100 of the embodiments described above, or a combination of modifications of the semiconductor devices 10 and 100.

The semiconductor devices 10 and 100 have a structure in which the source/drain structures SD or 180 are easily and directly connected to the back contact electrode BCE or 190.

According to the method of manufacturing a semiconductor device, process defects may be reduced during the formation of back contact electrodes.

The semiconductor devices 10 and 100 may be applied to various electronic apparatuses.

While the semiconductor devices, the electronic apparatuses including the semiconductor devices, and the semiconductor device manufacturing method have been described according to embodiments of the present disclosure with reference to the accompanying drawings, it will be understood by those of ordinary skill in the art that the embodiments are merely examples, and various modifications and other equivalent embodiments may be made therein. Therefore, the example embodiments described herein should be considered in a descriptive sense only and not for purposes of limitation. The various modifications and other equivalent embodiments are included within the scope of the present disclosure.

## Claims

1. A semiconductor device comprising:
a support structure layer comprising a first dielectric layer and a second dielectric layer;
a plurality of channel structures spaced apart from each other, in a first direction parallel to a first surface of the support structure layer, on the first surface of the support structure layer, the plurality of channel structures protruding in a fin shape in a direction away from the support structure layer, and comprising a semiconductor material;
a plurality of source/drain structures on the first surface of the support structure layer at opposite ends of each of the plurality of channel structures;
a plurality of gate structures spaced apart from each other, in a second direction parallel to the first surface and different from the first direction, on the first surface of the support structure layer, the plurality of gate structures surrounding three surfaces of each of the plurality of channel structures at different positions in the second direction;
back contact electrodes connected to first source/drain structures among the plurality of source/drain structures, the back contact electrodes penetrating the support structure layer, and exposed at a second surface of the support structure layer, opposite to the first surface; and
sacrificial structures inside the support structure layer and supporting second source/drain structures among the plurality of source/drain structures,
wherein the first dielectric layer is under and apart from the plurality of channel structures, and
wherein the second dielectric layer is between the first dielectric layer and the plurality of channel structures, and a thickness of a portion of the second dielectric layer directly below the plurality of channel structures is equal to a thickness of the sacrificial structures.

2. The semiconductor device of claim 1, wherein the first dielectric layer and the second dielectric layer have different etching rates from each other.

3. The semiconductor device of claim 1 or 2, wherein the first dielectric layer comprises silicon oxide, and
wherein the second dielectric layer comprises silicon nitride, silicon oxynitride, silicon carbonitride, or silicon carbon oxynitride.

4. The semiconductor device of any preceding claim, wherein the sacrificial structures comprise a material that is different from a material of the first dielectric layer or a material of the second dielectric layer.

5. The semiconductor device of any preceding claim, wherein the sacrificial structures comprise SiGe.

6. The semiconductor device of any preceding claim, wherein the first dielectric layer comprises a plurality of regions respectively facing the plurality of channel structures and spaced apart from each other, and optionally wherein the plurality of regions of the first dielectric layer each comprise a shape extending from the second surface of the support structure layer into the support structure layer, and further optionally wherein the support structure layer further comprises residual sacrificial patterns respectively between the first dielectric layer and the plurality of channel structures, the residual sacrificial patterns comprising a material that is identical to a material of the sacrificial structures.

7. The semiconductor device of claim 6, wherein the residual sacrificial patterns have a thickness that is equal to the thickness of the sacrificial structures.

8. The semiconductor device of claim 6 or 7, wherein the residual sacrificial patterns face regions between the plurality of gate structures.

9. The semiconductor device of any of claims 6 to 8, wherein regions of the second dielectric layer and the residual sacrificial patterns are alternately arranged in the second direction, and the regions of the second dielectric layer and the residual sacrificial patterns are between the plurality of regions of the first dielectric layer and the plurality of channel structures.

10. The semiconductor device of any preceding claim, wherein the second dielectric layer does not overlap with the plurality of channel structures in a third direction perpendicular to the first surface of the support structure layer, and
wherein the second dielectric layer comprises a first region and a plurality of second regions, the first region extending to a predetermined thickness from the second surface of the support structure layer toward the first surface of the support structure layer, and the plurality of second regions protruding from the first region to the first surface of the support structure layer, and optionally wherein the plurality of second regions face the plurality of gate structures, respectively, and further optionally wherein a lateral surface profile of the plurality of second regions and a lateral surface profile of the plurality of gate structures are continuous with respect to each other.

11. The semiconductor device of claim 10, wherein the support structure layer further comprises a third dielectric layer between the plurality of second regions, the third dielectric layer comprising a material that is identical to a material of the first dielectric layer.

12. The semiconductor device of claim 11, wherein the support structure layer further comprises a fourth dielectric layer that is conformally along a shape of the second dielectric layer and between the second dielectric layer and the third dielectric layer.

13. The semiconductor device of claim 12, wherein the fourth dielectric layer extends along lateral surfaces of the plurality of gate structures from lateral surfaces of the plurality of second regions, and optionally wherein the fourth dielectric layer comprises a material that is identical to a material of the second dielectric layer.

14. An electronic apparatus comprising:
a semiconductor device according to any preceding claim; and
a controller configured to control the semiconductor device.

15. A method of manufacturing a semiconductor device, the method comprising:
forming a plurality of three-dimensional structures on a bulk silicon layer, the plurality of three-dimensional structures being arranged with respect to each other in a first direction, and each of the plurality of three-dimensional structures comprising a first silicon layer, a sacrificial material layer, and a second silicon layer;
forming an isolation layer, between the plurality of three-dimensional structures, on the bulk silicon layer;
forming a plurality of dummy gates on the plurality of three-dimensional structures, the plurality of dummy gates crossing the plurality of three-dimensional structures and arranged with respect to each other in a second direction different from the first direction;
patterning the isolation layer using a hard mask used to form the plurality of dummy gates;
forming, on the isolation layer that is patterned, a support structure layer including a plurality of types of dielectric layers having different etching rates from each other;
forming, after the forming the support structure layer, a plurality of source/drain structures in contact with opposite ends of the second silicon layer and in contact with an upper surface of the sacrificial material layer of each of the plurality of three-dimensional structures;
exposing portions of the sacrificial material layer by removing the bulk silicon layer and the isolation layer;
forming sacrificial structures in contact with the plurality of source/drain structures by removing exposed portions of the sacrificial material layer; and
forming a back contact electrode connected to one of the plurality of source/drain structures, the back contact electrode exposed at a back surface of the support structure layer.
